# EUROPÄISCHE PATENTSCHRIFT

(11) **EP 2 347 482 B1**
(45) Veröffentlichungstag und Bekanntmachung des Hinweises auf die Patenterteilung: **25.01.2017**
(21) Anmeldenummer: 09765010.5
(22) Anmeldetag: 21.10.2009
(51) Int. Cl.: H01S 5/22, H01S 5/042, H01S 5/10

(54) **KANTENEMITTIERENDER HALBLEITERLASERCHIP**
EDGE-EMITTING SEMICONDUCTOR LASER CHIP
PUCE À SEMI-CONDUCTEURS À ÉMISSION latérale

(30) Priorität: 21.11.2008 DE 102008058436
(43) Veröffentlichungstag der Anmeldung: 27.07.2011
(73) Patentinhaber: OSRAM Opto Semiconductors GmbH, 93055 Regensburg (DE)
(72) Erfinder: LAUER, Christian, 93053 Regensburg (DE); KÖNIG, Harald, 93170 Bernhardswald (DE); REILL, Wolfgang, 93080 Pentling (DE); STRAUSS, Uwe, 93077 Bad Abbach (DE)
(74) Vertreter: Epping - Hermann - Fischer
(86) Internationale Anmeldenummer: PCT/DE2009/001482
(87) Internationale Veröffentlichungsnummer: WO 2010/057455

(56) Entgegenhaltungen:
- EP-A1- 0 386 634
- EP-A1- 1 906 498
- WO-A1-00/66614
- GB-A- 2 397 692
- US-A1- 2008 144 691

## Beschreibung

Es wird ein kantenemittierender Halbleiterlaserchip angegeben.

Die Druckschriften GB 2 397 692 A und EP 0 386 634 A1 beschreiben Halbleiterlaserchips.

Eine zu lösende Aufgabe besteht darin, einen kantenemittierenden Halbleiterlaserchip mit besonders guter Strahlqualität anzugeben.

Diese Aufgabe wird durch einen kantenemittierenden Halbleiterlaserchip gemäß Anspruch 1 gelöst.

Es wird ein kantenemittierender Halbleiterlaserchip angegeben. Bei dem kantenemittierenden Halbleiterlaserchip handelt es sich beispielsweise um einen Breitstreifenlaser, der einen oder mehrere Emitter umfassen kann. Umfasst der Breitstreifenlaser mehrere Emitter, so können vom kantenemittierenden Halbleiterlaserchip im Betrieb mehrere Laserstrahlen, die beabstandet zueinander sind, emittiert werden.

Gemäß zumindest einer Ausführungsform des kantenemittierenden Halbleiterlaserchips umfasst der kantenemittierende Halbleiterlaserchip einen Halbleiterkörper. Der Halbleiterkörper weist beispielsweise eine epitaktisch gewachsene Schichtenfolge auf.

Der Halbleiterkörper kann dabei zumindest eine aktive Zone umfassen, die Teil der epitaktisch gewachsenen Schichtenfolge ist. In der aktiven Zone wird im Betrieb des Halbleiterlaserchips elektromagnetische Strahlung erzeugt und verstärkt. Beispielsweise beinhaltet die aktive Zone einen oder mehrere Quantentöpfe, Quantendrähte oder Quantenpunkte.

Gemäß zumindest einer Ausführungsform des kantenemittierenden Halbleiterlaserchips umfasst der Halbleiterlaserchip einen Kontaktstreifen. Der Kontaktstreifen ist vorzugsweise an einer Deckfläche an der Oberseite des Halbleiterkörpers angeordnet. Bei dem Kontaktstreifen kann es sich um eine Elektrode handeln, über die elektrischer Strom in den Halbleiterkörper eingeprägt werden kann. Diese kann zum Beispiel als streifenförmige Metallisierung auf die Deckfläche des Halbleiterkörpers aufgebracht sein. Darüber hinaus ist es auch möglich, dass der Kontaktstreifen mittels eines streifenförmigen Durchbruchs in einer Passivierungsschicht auf der Deckfläche des Halbleiterkörpers definiert ist. Auf diese Passivierung kann eine Metallschicht großflächig aufgebracht sein. Die Metallschicht befindet sich dann nur im Bereich des Durchbruchs in Kontakt mit dem Halbleiterkörper.

Mittels des eingeprägten elektrischen Stroms wird in der aktiven Zone des Halbleiterkörpers elektromagnetische Strahlung erzeugt. Die elektromagnetische Strahlung wird in der aktiven Zone unterhalb des Kontaktstreifens erzeugt. Dort befindet sich also der Emitter des Halbleiterlaserchips. Weist der Halbleiterlaserchip mehrere Kontaktstreifen an der Deckfläche des Halbleiterkörpers auf, so wird unterhalb eines jeden Kontaktstreifens Laserstrahlung erzeugt. Der Halbleiterlaserchip weist dann mehrere Emitter auf, deren Zahl höchstens der Anzahl der Kontaktstreifen auf der Deckfläche entspricht. Bei dem kantenemittierenden Halbleiterlaserchip handelt es sich also um einen elektrisch gepumpten Halbleiterlaserchip.

Der Kontaktstreifen ist beispielsweise als Metallisierung auf der Deckfläche des Halbleiterkörpers angeordnet. Der Kontaktstreifen kann sich dabei entlang der Hauptabstrahlrichtung der in der aktiven Zone erzeugten elektromagnetischen Strahlung erstrecken. Die Haupterstreckungsrichtung des Kontaktstreifens ist dann parallel zur Hauptabstrahlrichtung des Emitters, der dem Kontaktstreifen zugeordnet ist. Beispielsweise erstreckt sich der Kontaktstreifen als Streifen gleichmäßiger Breite entlang der Hauptabstrahlrichtung der im Halbleiterkörper erzeugten elektromagnetischen Strahlung.

Gemäß zumindest einer Ausführungsform des kantenemittierenden Halbleiterlaserchips umfasst der kantenemittierende Halbleiterlaserchip zumindest eine, vorzugsweise zumindest zwei Begrenzungsstrukturen zur Begrenzung der Stromaufweitung im Halbleiterkörper zwischen dem Kontaktstreifen und der aktiven Zone. Die Begrenzungsstrukturen verhindern eine zu große Stromaufweitung zwischen dem Kontaktstreifen und der aktiven Zone. Das heißt, Strom, der durch den Kontaktstreifen in den Halbleiterkörper eingeprägt wird, wird zum Beispiel in lateraler Richtung - die Richtung die in der Ebene der Deckfläche senkrecht zur Haupterstreckungsrichtung des Kontaktstreifens verläuft - an einer Aufweitung gehindert. Dadurch liegt direkt unterhalb des Kontaktstreifens in der aktiven Zone eine hohe Strom- und Ladungsträgerdichte vor, wohingegen die Stromdichte mit Abstand zum Kontaktstreifen abnimmt. Das heißt, aufgrund der Begrenzungsstrukturen bildet sich in der aktiven Zone eine Stromdichte aus, die im Bereich der aktiven Zone, der unmittelbar unter dem Kontaktstreifen liegt, ein lokales Maximum haben kann.

Gemäß zumindest einer Ausführungsform des Halbleiterlaserchips sind die Begrenzungsstrukturen beidseitig des Kontaktstreifens angeordnet. Das heißt, der kantenemittierende Halbleiterlaserchip umfasst zumindest zwei Begrenzungsstrukturen, wobei je zumindest eine Begrenzungsstruktur in Richtung der Haupterstreckungsrichtung des Kontaktstreifens gesehen, links beziehungsweise rechts vom Kontaktstreifen angeordnet ist. Beispielsweise sind die Begrenzungsstrukturen symmetrisch zum Kontaktstreifen angeordnet, wobei eine Längsmittelachse des Kontaktstreifens die Symmetrieachse bildet.

Es ist jedoch auch denkbar, dass die zumindest eine Begrenzungsstruktur nur auf einer Seite des Kontaktstreifens angeordnet ist.

Gemäß zumindest einer Ausführungsform des kantenemittierenden Halbleiterlaserchips umfasst der Halbleiterlaserchip einen Halbleiterkörper, der zumindest eine aktive Zone umfasst, in der im Betrieb des Halbleiterlaserchips elektromagnetische Strahlung erzeugt wird. Darüber hinaus umfasst der Halbleiterlaserchip zumindest einen Kontaktstreifen, der auf einer Deckfläche an einer Oberseite des Halbleiterkörpers angeordnet ist. Der Halbleiterlaserchip umfasst zudem zwei Begrenzungsstrukturen zur Begrenzung der Stromaufweitung zwischen dem Kontaktstreifen und der aktiven Zone, wobei die Begrenzungsstrukturen beidseitig vom Kontaktstreifen angeordnet sind.

Insbesondere handelt es sich bei den Begrenzungsstrukturen zur Begrenzung der Stromaufweitung nicht um Strombarrieren. Das heißt, durch die Begrenzungsstrukturen wird eine laterale Stromaufweitung, also eine Stromaufweitung in Richtungen quer zur Haupterstreckungsrichtung des Kontaktstreifens - gehemmt, jedoch nicht gänzlich verhindert. Mit anderen Worten kann trotz der Begrenzungsstrukturen auch in Randbereichen der aktiven Zone, die vom Kontaktstreifen weiter entfernt sind, als der direkt unter dem Kontaktstreifen liegende zentrale Bereich der aktiven Zone, eine Bestromung und damit eine Erzeugung von elektromagnetischer Strahlung erfolgen. Jedoch erfolgt in den Randbereichen der aktiven Zone aufgrund der Begrenzungsstrukturen eine reduzierte Bestromung, so dass die Stromdichte in der aktiven Zone im Bereich des Kontaktstreifens ein lokales Maximum aufweist. Das derart erzeugte Ladungsträgerdichteprofil führt zu einer Vergrößerung des Überlapps des lateralen Gewinnprofils des Halbleiterlaserchips mit niedrigen Lateralmoden und einer Verringerung des Überlapps mit höheren Moden.

Des Weiteren führt das angesprochene Ladungsträgerdichteprofil über den Plasma-Effekt im Randbereich der aktiven Zone zu einer entsprechenden räumlichen Variation des Brechungsindex in der aktiven Zone. Dadurch wird die in der aktiven Zone erzeugte Welle elektromagnetischer Strahlung gestreut und mit Verlusten beaufschlagt. Dieser Mechanismus wirkt auf höhere laterale Moden stärker als auf niedrigere laterale Moden - zum Beispiel die Grundmode. Insgesamt werden also durch die Begrenzungsstrukturen die niedrigeren lateralen Moden in ihrer Anregung bevorzugt, wohingegen die Anregung von höheren lateralen Moden unterdrückt wird. Beispielsweise ist es durch die angegebene Ausgestaltung des Halbleiterlaserchips möglich, Laserstrahlung der lateralen Grundmode im Vergleich zu höheren Moden in größerem Umfang zu verstärken, als dies ohne die angegebene Ausgestaltung des Halbleiterchips der Fall wäre. Höhermodige Laserstrahlung wird aufgrund der Begrenzungsstrukturen weniger stark gepumpt und gegebenenfalls mit Streuverlusten beaufschlagt. Die höheren Moden können dann nicht anschwingen.

Bei den Begrenzungsstrukturen handelt es sich nicht um Strombarrieren, bei denen zur Unterbindung einer lateralen Stromaufweitung ein Graben bis in die aktive Zone geätzt wird, der mit einem Absorbermaterial befüllt sein kann. Aufgrund der Tatsache, dass es sich bei den Begrenzungsstrukturen nicht um Strombarrieren handelt, können die Begrenzungsstrukturen, im Gegensatz zu Strombarrieren, besonders nah an den Kontaktstreifen geführt werden. Dies kann ohne Beschädigung der aktiven Zone - beispielsweise durch Ätzen - erfolgen. Die Beschädigung würde zu einer Verschlechterung der der Effizienz und der Lebensdauer des kantenemittierenden Halbleiterlaserchips führen. Im Gegensatz zu einer Strombarriere wird durch die Begrenzungsstrukturen der eingeprägte Strom nicht auf einen kleinen Bereich eingeschnürt, sondern in lateraler Richtung derart abgeschwächt, dass höhere laterale Moden nur in reduziertem Umfang gepumpt werden.

Die Begrenzungsstrukturen erstrecken sich vorzugsweise nicht bis in die aktive Zone. Die aktive Zone bleibt vorzugsweise stets frei von den Begrenzungsstrukturen.

Gemäß zumindest einer Ausführungsform des kantenemittierenden Halbleiterlaserchips umfasst der Halbleiterlaserchip eine Vielzahl von Begrenzungsstrukturen, die in einer Haupterstreckungsrichtung des Kontaktstreifens beabstandet zueinander angeordnet sind. Das heißt, der Halbleiterlaserchip umfasst drei oder mehr Begrenzungsstrukturen. Die Begrenzungsstrukturen können beidseitig vom Kontaktstreifen angeordnet sein. Benachbarte Begrenzungsstrukturen sind auf einer selben Seite des Kontaktstreifens entlang der Haupterstreckungsrichtung des Kontaktstreifens beabstandet zueinander angeordnet. Das heißt, die Begrenzungsstrukturen auf einer Seite des Kontaktstreifens hängen in dieser Ausführungsform nicht zusammen, sondern sind durch Bereiche voneinander getrennt, in denen keine Begrenzungsstrukturen vorhanden sind. Zum Beispiel beträgt der Abstand wenigstens 5 µm, zum Beispiel 10 µm.

Gemäß zumindest einer Ausführungsform des kantenemittierenden Halbleiterlaserchips umfasst der Halbleiterkörper des Halbleiterlaserchips eine Kontaktschicht, die an den Kontaktstreifen grenzt. Bei der Kontaktschicht handelt es sich um diejenige Schicht des Halbleiterkörpers, welche die Deckfläche umfasst. Die Kontaktschicht ist mit einem hochdotierten Halbleitermaterial gebildet und dient dazu, durch den Kontaktstreifen eingeprägten Strom in lateraler Richtung, das heißt quer zur Haupterstreckungsrichtung des Kontaktstreifens, aufzuweiten.

Der Halbleiterkörper umfasst ferner eine Mantelschicht, die an die dem Kontaktstreifen abgewandte Seite der Kontaktschicht grenzt.

Der Halbleiterkörper umfasst weiter eine Wellenleiterschicht, die an die der Kontaktschicht abgewandten Seite der Mantelschicht grenzt. Mit ihrer der Mantelschicht abgewandten Seite grenzt die Wellenleiterschicht an die aktive Zone des Halbleiterlaserchips. Die aktive Zone ist dabei von zwei Wellenleiterschichten umschlossen, die gleich oder unterschiedlich ausgebildet sein können.

Die Wellenleiterschicht weist einen höheren Bandabstand und eine geringere optische Brechzahl als die aktive Zone auf. Die Mantelschicht wiederum weist einen höheren Bandabstand und eine geringere optische Brechzahl als die Wellenleiterschicht auf. Die im Betrieb des Halbleiterlaserchips im Halbleiterkörper erzeugte elektromagnetische Strahlung breitet sich entlang des Kontaktstreifens in der Wellenleiterschicht und in der Mantelschicht aus.

Gemäß zumindest einer Ausführungsform des kantenemittierenden Halbleiterlaserchips erstreckt sich zumindest eine der Begrenzungsstrukturen bis in die Mantelschicht, wobei die Wellenleiterschicht frei von der Begrenzungsstruktur ist. Das heißt, die Begrenzungsstruktur erstreckt sich durch die Kontaktschicht hindurch in die Mantelschicht. Die Kontaktschicht selbst ist durch die Begrenzungsstruktur stellenweise durchbrochen. Beispielsweise ist es möglich, dass zumindest eine der Begrenzungsstrukturen genau bis zur Mantelschicht reicht.

Je nach Höhe des durch den Kontaktstreifen eingeprägten Stroms kann dabei das Durchbrechen der Kontaktschicht ausreichend sein. Für höhere Ströme kann es jedoch notwendig sein, dass sich die Begrenzungsstruktur bis in die Mantelschicht erstreckt, um eine ausreichende Beschränkung der Stromaufweitung zu erzielen. Beispielsweise erstreckt sich zumindest eine der Begrenzungsstrukturen bis zu einem Abstand von wenigstens 300 nm vor die Wellenleiterschicht. Dabei ist es auch möglich, dass sämtliche Begrenzungsstrukturen sich bis in die Mantelschicht erstrecken. Beispielsweise ist es dann auch möglich, dass sämtliche Begrenzungsstrukturen die gleiche Eindringtiefe in den Halbleiterkörper aufweisen. Das heißt, zum Beispiel können sich alle Begrenzungsstrukturen bis zu 300 nm über der Wellenleiterschicht erstrecken.

Gemäß zumindest einer Ausführungsform des kantenemittierenden Halbleiterlaserchips erstreckt sich zumindest eine Begrenzungsstruktur in die Wellenleiterschicht, wobei die aktive Zone von der Begrenzungsstruktur frei bleibt. Das heißt, die Begrenzungsstruktur durchbricht die Kontaktschicht und die Mantelschicht und reicht wenigstens bis zur Wellenleiterschicht und kann sich in diese erstrecken. Eine solche Begrenzungsstruktur stellt eine besonders effektive Begrenzung der Stromaufweitung zwischen Kontaktschicht und aktiver Zone dar. Die aktive Zone bleibt jedoch frei von der Begrenzungsstruktur, so dass es sich bei der Begrenzungsstruktur nicht um eine Strombarriere handelt, die ein Einprägen über sie hinaus in die aktive Zone vollständig unterbindet. Beispielsweise erstreckt sich die Begrenzungsstruktur bis zu einer Eindringtiefe von wenigstens 150 nm über der aktiven Zone in die Wellenleiterschicht. Dabei ist es wiederum möglich, dass sich sämtliche Begrenzungsstrukturen des Hälbleiterlaserchips in die Wellenleiterschicht erstrecken und dabei die gleiche Eindringtiefe in den Halbleiterkörper aufweisen.

Zudem ist es möglich, dass sich die Begrenzungsstrukturen im Hinblick auf ihre Eindringtiefe voneinander unterscheiden. Über die Eindringtiefe der Begrenzungsstrukturen im Halbleiterkörper ist es beispielsweise möglich, die Stromführung entlang des Kontaktstreifens anzupassen. Dabei ist es möglich, dass sich Begrenzungsstrukturen bis in die Mantelschicht, jedoch nicht in die Wellenleiterschicht erstrecken, wohingegen sich andere Begrenzungsstrukturen bis in die Wellenleiterschicht jedoch nicht bis in die aktive Zone erstrecken.

Gemäß der Erfindung sind die Begrenzungsstrukturen mit einem Füllfaktor von wenigstens 10 % und höchstens 90% beidseitig vom Kontaktstreifen angeordnet. Als Füllfaktor wird dabei das Verhältnis der Summe der maximalen Breiten der Begrenzungsstrukturen in Haupterstreckungsrichtung des Kontaktstreifens zur Gesamtlänge des Kontaktstreifens verstanden. Erstreckt sich beispielsweise eine einzige Begrenzungsstruktur auf einer Seite entlang des gesamten Kontaktstreifens, so beträgt der Füllfaktor 100 %. Beträgt die Summe der maximalen Breiten der Begrenzungsstrukturen gerade 10 % der Länge des Kontaktstreifens, so beträgt der Füllfaktor 10 %. Der Füllfaktor kann dabei für die zwei Seiten - links und rechts zum Kontaktstreifen - getrennt bestimmt werden und sich für die beiden Seiten unterscheiden. Vorzugsweise ist der Füllfaktor beidseitig vom Kontaktstreifen jedoch gleich gewählt und beträgt für beide Seiten wenigstens 10 %.

Die Begrenzungsstrukturen erstrecken sich somit nicht ununterbrochen entlang der gesamten Länge des Kontaktstreifens.

Dabei ist es möglich, dass der Füllfaktor lokal in lateraler Richtung, das heißt in Richtung quer, zum Beispiel senkrecht, zur Haupterstreckungsrichtung des Kontaktstreifens, variiert. Beispielsweise können die Begrenzungsstrukturen sich in Richtung zum Kontaktstreifen und/oder in Richtung weg vom Kontaktstreifen verjüngen. Durch die Wahl der Form der Begrenzungsstrukturen sowie die Wahl ihrer maximalen Breite kann die Wirkung der Begrenzungsstrukturen auf die Stromaufweitung sowie auf die Streuung der in der aktiven Zone erzeugten elektromagnetischen Strahlung eingestellt werden.

Gemäß zumindest einer Ausführungsform des kantenemittierenden Halbleiterlaserchips ist zumindest eine Begrenzungsstruktur in einem Abstand von höchstens 30 µm seitlich vom Kontaktstreifen angeordnet. Der Abstand zwischen dem Kontaktstreifen und der Begrenzungsstruktur wird dabei von der der Begrenzungsstruktur zugewandten Seitenfläche des Kontaktstreifens zum dem Kontaktstreifen am nächsten liegenden Punkt der Begrenzungsstruktur entlang einer Richtung gemessen, die parallel zur Ebene der Deckfläche des Halbleiterkörpers und senkrecht zur Haupterstreckungsrichtung des Kontaktstreifens verläuft. Die Begrenzungsstruktur kann sich in dieser Richtung über mehrere Mikrometer erstrecken. Ein derart nahes Anordnen der Begrenzungsstruktur am Kontaktstreifen führt zu einer besonders guten Konzentration der Ladungsträgerdichte in der aktiven Zone in Bereichen unmittelbar unterhalb des Kontaktstreifens. Die Begrenzungsstruktur kann dabei auch in den Kontaktstreifen ragen. Der Abstand zwischen dem Kontaktstreifen und der Begrenzungsstruktur beträgt dabei zum Beispiel zwischen wenigstens -30 µm bis höchstens 30 µm, vorzugsweise zwischen wenigstens - 20 µm bis höchstens 10 µm.

Gemäß zumindest einer Ausführungsform des kantenemittierenden Halbleiterlaserchips sind die Begrenzungsstrukturen innerhalb von zwei Begrenzungsstreifen beidseitig vom Kontaktstreifen angeordnet, wobei die Begrenzungsstreifen jeweils eine Breite von höchstens 1 mm aufweisen. Bevorzugt beträgt die Breite weniger als 250 µm, besonders bevorzugt weniger als 100 µm, zum Beispiel 60 µm. Das heißt, an beiden Seiten des Kontaktstreifens beträgt in dieser Ausführungsform der maximale Abstand zwischen dem Kontaktstreifen, also zwischen der Seitenfläche des Kontaktstreifens, die der Begrenzungsstruktur am nächsten liegt, und dem Ende der jeweiligen Begrenzungsstruktur, das vom Kontaktstreifen am weitesten entfernt ist, höchstens 1 mm. Das heißt, die Begrenzungsstrukturen sind in dieser Ausführungsform in Streifen links und rechts vom Kontaktstreifen angeordnet, die eine Breite von höchstens 1 mm aufweisen. Es hat sich dabei gezeigt, dass derart geringe Breiten des Begrenzungsstreifens ausreichend sind, um eine Stromaufweitung zwischen Kontaktstreifen und aktiver Zone effektiv zu begrenzen.

Gemäß zumindest einer Ausführungsform des kantenemittierenden Halbleiterlaserchips ist zumindest eine der Begrenzungsstrukturen durch ein Implantationsgebiet im Halbleiterkörper gebildet. Beispielsweise können dann alle Begrenzungsstrukturen durch ein Implantationsgebiet im Halbleiterkörper gebildet sein.

Das heißt, die Begrenzungsstruktur ist durch einen räumlich ausgedehnten Bereich im Halbleiterkörper gebildet, der durch die Implantation von Ionen in das Kristallgitter des Halbleiterkörpers erzeugt ist. Je nach Eindringtiefe der Begrenzungsstruktur in den Halbleiterkörper werden Ionen bis in die Mantelschicht oder bis in die Wellenleiterschicht in das Kristallgitter des Halbleiterkörpers implantiert. Durch die Implantation von Ionen ist die elektrische Leitfähigkeit im Halbleiterkörper stark verringert und die Stromaufweitung im Bereich der Begrenzungsstruktur weitgehend unterbunden. Auf diese Weise bildet sich das implantierte Profil als Gewinnprofil des Halbleiterlasers ab.

Beispielsweise könne Protonen in den Halbleiterkörper implantiert werden.

Gemäß zumindest einer Ausführungsform des kantenemittierenden Halbleiterlaserchips ist zumindest eine der Begrenzungsstrukturen durch eine Ausnehmung im Halbleiterkörper gebildet. Beispielsweise können dann sämtliche Begrenzungsstrukturen durch eine Ausnehmung im Halbleiterkörper gebildet sein.

Das heißt, die Begrenzungsstruktur ist durch eine Ausnehmung gebildet, in deren Bereich das Material des Halbleiterkörpers entfernt ist. Beispielsweise kann das Bilden der Ausnehmung, die die Begrenzungsstrukturen bildet, durch Ätzen erfolgen.

Gemäß zumindest einer Ausführungsform des kantenemittierenden Halbleiterlaserchips ist die Ausnehmung mit einem Füllmaterial gefüllt, das vom Halbleiterkörper verschieden ist. Beispielsweise ist in die Ausnehmung, die eine Begrenzungsstruktur bildet, ein Material wie Siliziumnitrid, Germanium und/oder ein Metall wie Gold oder Platin eingebracht. Die Ausnehmung ist dabei nicht unbedingt vollständig vom Material befüllt, sondern es hat sich als ausreichend herausgestellt, wenn die Ausnehmung an ihrer der Deckfläche des Halbleiterkörpers zugewandten Öffnung in einer dünnen Schicht vom Material überdeckt ist. Das heißt, nur die Seitenflächen und die Bodenfläche der Ausnehmung sind dann mit dem Füllmaterial versehen, ohne dass die Ausnehmung vom Füllmaterial ausgefüllt ist.

Ferner kann die Ausnehmung in einer Richtung parallel zum Kontaktstreifen durch eine Fülllinie getrennt sein. Vom Kontaktstreifen bis zur Fülllinie ist die Ausnehmung frei von einem Festkörper-Füllmaterial und zum Beispiel mit Luft gefüllt. Ab der Fülllinie, in Richtung weg vom Kontaktstreifen, ist die Ausnehmung dann mit dem Füllmaterial befüllt.

Die Ausnehmung kann auch gänzlich frei von einem Füllmaterial sein. Es befindet sich dann Luft in der Ausnehmung.

Bei dem Füllmaterial kann es sich um einen optischen Absorber handeln, der auftreffende elektromagnetische Strahlung absorbiert. Dadurch wird die Wirkung der Begrenzungsstrukturen neben ihrer Eigenschaft zur Begrenzung der Stromaufweitung durch eine Streuung und/oder Absorption der in sie eintretenden elektromagnetischen Welle verstärkt. Bei dem Absorber handelt es sich zum Beispiel um amorphes Germanium, das sich durch eine hohe Brechzahl und hohe optische Verluste der elektromagnetischen Strahlung, die in das Germanium eindringt, auszeichnet.

Aufgrund ihrer Lage seitlich vom Kontaktstreifen werden dabei überwiegend höhere laterale Moden des Halbleiterlasers unterdrückt.

Gemäß zumindest einer Ausführungsform des kantenemittierenden Halbleiterlaserchips ist der Halbleiterkörper in der Ausnehmung, zumindest im Bereich einer Bodenfläche der Ausnehmung, zusätzlich dotiert. Beispielsweise kann der Halbleiterkörper dort mit Germanium dotiert werden. Durch die Dotierung ist im Halbleiterkörper eine pn-pn-Struktur gebildet, die ebenfalls die Absorption der eintretenden elektromagnetischen Welle verstärken kann. Dabei ist es auch möglich, dass der Halbleiterkörper im gesamten Bereich der Ausnehmung - also an Bodenfläche und Seitenflächen der Ausnehmung dotiert ist.

Gemäß zumindest einer Ausführungsform des kantenemittierenden Halbleiterlaserchips umfasst zumindest eine Begrenzungsstruktur eine Aufrauung des Halbleiterkörpers.

Aufgrund der Aufrauung wird die im Halbleiterlaserchip umlaufende Welle im Außenbereich des Emitters statistisch gestreut, wodurch höhere Lateralmoden im Halbleiterlaserchip weiter unterdrückt werden. Ferner werden Ringresonanzen aufgrund der statistischen Streuung durch die Aufrauung des Halbleiterkörpers vermieden. Es ist dabei möglich, dass sämtliche Begrenzungsstrukturen des Halbleiterkörpers eine solche Aufrauung umfassen. Beispielsweise kann es sich bei der Begrenzungsstruktur um eine Ausnehmung im Halbleiterkörper handeln. Die Bodenfläche der Ausnehmung, das heißt, die der Deckfläche abgewandte tiefste Stelle der Ausnehmung, kann statistisch aufgeraut sein. Darüber hinaus kann die Aufrauung beispielsweise auch mit dem Befüllen der Ausnehmung mit einem Füllmaterial kombiniert werden. Das heißt, es kann zum Beispiel die Bodenfläche einer Ausnehmung aufgeraut sein und die Ausnehmung gleichzeitig mit einem Füllmaterial befüllt sein, dass vom Material des Halbleiterkörpers verschieden ist.

Gemäß zumindest einer Ausführungsform des kantenemittierenden Halbleiterlaserchips umfasst zumindest eine der Begrenzungsstrukturen eine Seitenfläche, die an den Halbleiterkörper grenzt. Handelt es sich bei der Begrenzungsstruktur beispielsweise um ein Implantationsgebiet im Halbleiterkörper, so ist die Seitenfläche der Begrenzungsstruktur durch die Außenfläche des Implantationsgebiets gebildet, mit der das Implantationsgebiet an den angrenzenden Halbleiterkörper sich anschließt. Die Begrenzungsstruktur weist neben einer Seitenfläche eine Bodenfläche auf, die parallel oder im Wesentlichen parallel zur Deckfläche des Halbleiterkörpers verläuft.

Gemäß zumindest einer Ausführungsform des kantenemittierenden Halbleiterlaserchips weist die Begrenzungsstruktur zumindest eine Seitenfläche auf, die mit der Deckfläche des Halbleiterkörpers einen Winkel von wenigsten 20° und höchstens 80° einschließt, zum Beispiel zwischen wenigstens 30° und höchstens 70°. Vorzugsweise gilt dies dann für sämtliche Seitenflächen der Begrenzungsstruktur. Der angesprochene Winkelbereich hat sich dabei insbesondere für Begrenzungsstrukturen als vorteilhaft erwiesen, die in die Mantelschicht oder in die Wellenleiterschicht hinein reichen. Bei flacheren oder steileren Winkeln wird die im Halbleiterlaserchip umlaufende elektromagnetische Welle vor und zurück oder gar nicht gestreut. Für Begrenzungsstrukturen mit Seitenflächen, die im angegebenen Winkelbereich zur Deckfläche verlaufen, ist die Streuung in die strahlungsabsorbierende Kontaktschicht beziehungsweise das strahlungsabsorbierende Substrat jedoch erhöht. Darüber hinaus weisen Begrenzungsstrukturen mit Flankenwinkeln im genannten Bereich aufgrund des abrupteren Übergangs beim Eintritt der Welle in die Begrenzungsstruktur eine stärkere Streuwirkung als Begrenzungsstrukturen mit geringeren Flankenwinkeln auf, da dann Koppelverluste an der Grenzfläche zwischen Begrenzungsstruktur und Halbleiterkörper vergrößert sind.

Gemäß zumindest einer Ausführungsform des kantenemittierenden Halbleiterlaserchips weist zumindest eine Begrenzungsstruktur eine Seitenfläche auf, die an den Halbleiterkörper grenzt, wobei die Seitenfläche mit der Haupterstreckungsrichtung des Kontaktstreifens einen Winkel zwischen 15° und 75° einschließt. Das heißt, in Draufsicht auf die Deckfläche des Halbleiterlaserchips weisen die Begrenzungsstrukturen in diesem Ausführungsbeispiel Seitenflächen auf, die nicht senkrecht zum Kontaktstreifen verlaufen, sondern einen Winkel zwischen wenigstens 15° und höchstens 75° mit der Haupterstreckungsrichtung des Kontaktstreifens einschließen. Das heißt, die Seitenflächen der Begrenzungsstrukturen verlaufen nicht parallel und / oder senkrecht zu den Facetten des Halbleiterlasers, die vorzugsweise senkrecht zur Haupterstreckungsrichtung des Kontaktstreifens ausgerichtet sind. Die Seitenflächen der Begrenzungsstruktur schließen also einen Winkel ungleich 90° und / oder 0° mit der Abstrahlrichtung des Halbleiterlasers ein. Auf die Seitenflächen auftreffende elektromagnetische Strahlung wird damit vom Emitter weggestreut. Ferner verlaufen die Seitenflächen nicht zwingend parallel zueinander. Das heißt, die Seitenflächen der Begrenzungsstrukturen können Winkel größer 0° miteinander einschließen.

Gemäß zumindest einer Ausführungsform des kantenemittierenden Halbleiterlaserchips sind beidseitig vom Kontaktstreifen entlang der Haupterstreckungsrichtung des Kontaktstreifens Strombarrieren angeordnet, wobei der Kontaktstreifen und die Begrenzungsstrukturen lateral zwischen den Strombarrieren angeordnet sind. Das heißt, die Strombarrieren schließen links und rechts vom Kontaktstreifen diesen und die Begrenzungsstrukturen am Kontaktstreifen ein. Die Strombarrieren sind beispielsweise durch V-förmige Gräben gebildet, die sich bis zur aktiven Zone erstrecken. Die V-förmigen Gräben können mit einem strahlungsabsorbierenden Material, wie beispielsweise amorphem Germanium, befüllt sein.

Beispielsweise durch die Begrenzungsstrukturen von der aktiven Zone und dem Kontaktstreifen weg gestreute elektromagnetische Strahlung kann von den Strombarrieren absorbiert werden, so dass sich kein Eindringen dieser Strahlung in benachbarte Emitter des Halbleiterlaserchips ergeben kann. Darüber hinaus verhindern die Strombarrieren auch, dass durch den Kontaktstreifen in den Halbleiterlaserchip eingeprägter Strom von einem Emitter zu einem benachbarten Emitter des Halbleiterlaserchips gelangen kann. Das heißt, die Strombarrieren können zwischen den einzelnen Emittern und damit zwischen den Kontaktstreifen der einzelnen Emitter angeordnet sein. Sie erweisen sich daher insbesondere auch für den Fall als besonders vorteilhaft, dass der Halbleiterlaserchip mehrere Emitter umfasst.

Im Folgenden wird der hier beschriebene kantenemittierende Halbleiterlaserchip anhand von Ausführungsbeispielen und den zugehörigen Figuren näher erläutert.
- Die Figur 1: zeigt anhand einer schematischen Draufsicht die Einkoppelung von Laserstrahlung in eine Faseroptik.
- Die Figur 2: zeigt aufgetragene Messwerte der Strahldivergenz im Winkelgrad gegen die Ausgangsleistung eines kantenemittierenden Halbleiterlaserchips.
- Die Figur 3: zeigt einen kantenemittierenden Halbleiterlaserchip gemäß dem Stand der Technik.
- Die Figur 4: zeigt aufgetragene Messwerte der Strahldivergenz im Winkelgrad gegen die Ausgangsleistung für zwei kantenemittierende Halbleiterlaserchips.
- Die Figur 5: zeigt anhand einer schematischen Schnittdarstellung ein Ausführungsbeispiel eines hier beschriebenen kantenemittierenden Halbleiterlaserchips.
- Die Figur 6: zeigt aufgetragene Messwerte im Winkelgrad gegen die Ausgangsleistung für den in Verbindung mit der Figur 5 beschriebenen kantenemittierenden Halbleiterlaserchip.
- Die Figuren 7 bis 17: zeigen schematische Draufsichten für Ausführungsbeispiele von hier beschriebenen kantenemittierenden Halbleiterlaserchips.
- Die Figuren 18a bis 18f: zeigen Ausführungsbeispiele von Begrenzungsstrukturen von hier beschriebenen kantenemittierenden Halbleiterlaserchips.

In den Ausführungsbeispielen und Figuren sind gleiche oder gleichwirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

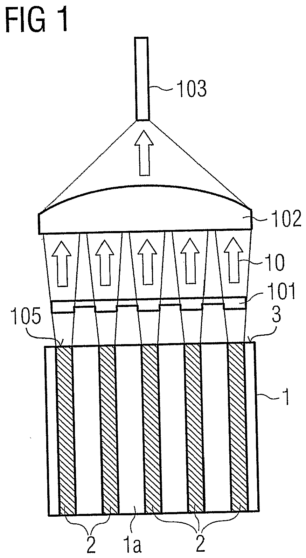

Die Figur 1 zeigt anhand einer schematischen Draufsicht die Einkopplung von Laserstrahlung 10, welche durch einen kantenemittierenden Halbleiterlaserchip 1 erzeugt wird, in eine Faseroptik 103. Die Figur 1 zeigt dabei einen kantenemittierenden Halbleiterlaserchip 1, welcher beispielhaft als Laserbarren mit fünf Emittern 105 ausgebildet ist. Der kantenemittierende Halbleiterlaserchip weist dafür an seiner Deckfläche 1a fünf Kontaktstreifen 2 auf. An der Auskoppelfacette 3 werden fünf Laserstrahlen 10 ausgekoppelt, welche zunächst durch eine Mikrooptik 101 treten. Durch ein weiteres optisches Element 102, das beispielsweise eine Sammellinse ist, wird die Laserstrahlung zusammengeführt und in die Faseroptik 103 eingekoppelt.

Der technische Fortschritt bei der Realisierung von Faserlasern und fasergekoppelten Lasern, die hervorragende Strahlqualität und hohe erreichbare Ausgangsleistungen ermöglichen, erlauben zum Beispiel ihren Einsatz in neuen industriellen Anwendungen wie dem "Remote"-Schweißen. Als Pumplichtquelle werden üblicherweise kantenemittierende Halbleiterlaserchips verwenden. Sie bieten einen sehr hohen Wirkungsgrad bei der Umwandlung der elektrisch aufgewendeten Leistung in nutzbare Strahlungsleistung bei gleichzeitig hoher optischer Ausgangsleistung. Andererseits zeigen sie jedoch eine starke Elliptizität des Fernfeldes. Eine effiziente Einkopplung der Laserstrahlung in den runden Faserquerschnitt einer Faseroptik 103 ist nur mit Hilfe teurer und aufwändig zu justierender Mikrooptiken 101 zu erreichen.

Eine Vereinfachung und Verbesserung der Faserkopplung der Laserdioden würde zu kostengünstigeren und zuverlässigeren Lasersystemen führen. Der Justageaufwand der Mikrooptiken verringert sich drastisch, wenn die Strahldivergenz zumindest in der ohnehin schmäleren lateralen Richtung r - die so genannte slow axis Richtung - kleiner wäre und der Strahl für effiziente Faserkopplung nur in der vertikalen Richtung - das heißt in der Richtung senkrecht zur Ebene, in der beispielsweise die Deckfläche 1a des Halbleiterlaserchips liegt - stark transformiert werden muss.

Die laterale Richtung r ist dabei diejenige Richtung, die zur Haupterstreckungsrichtung R des Kontaktstreifens 2 in einer zur Deckfläche 1a parallelen Ebene senkrecht verläuft. Die Haupterstreckungsrichtung R des Kontaktstreifens 2 verläuft parallel zur Ausbreitungsrichtung der im Betrieb des kantenemittierenden Halbleiterlaserchips 1 erzeugten elektromagnetischen Strahlung 10.

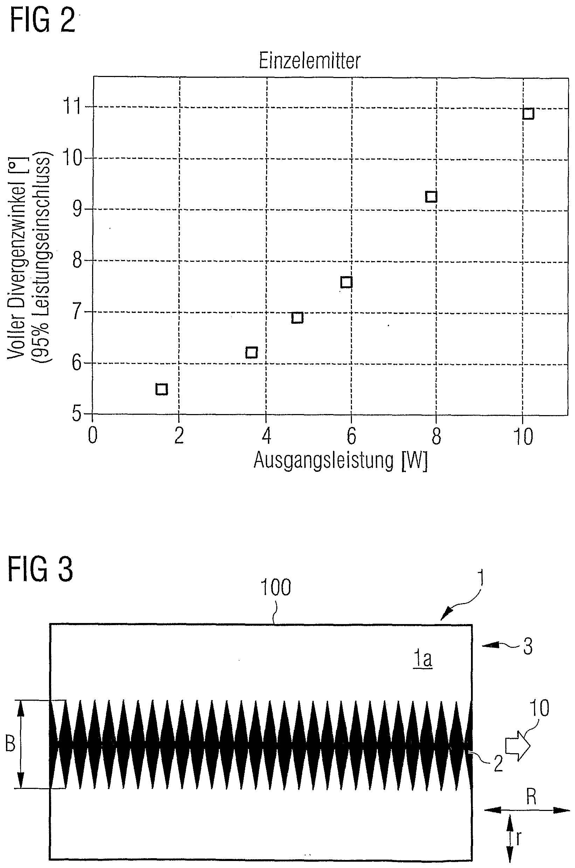

Die Figur 2 zeigt aufgetragene Messwerte der Strahldivergenz in Winkelgrad gegen die Ausgangsleistung eines kantenemittierenden Halbleiterlaserchips pro Emitter 105. Dabei wurde die Strahldivergenz bei 95 % Leistungseinschluss bestimmt. Die Strahldivergenz wurde in der "slow axis" (SA) Richtung, also in lateraler Richtung r in einer Ebene, die parallel zur Deckfläche 1a und senkrecht zur Haupterstreckungsrichtung R des Kontaktstreifens 2 (vergleiche dazu auch Figur 1) verläuft, bestimmt. "95 % Leistungseinschluss" bedeutet, dass für die Bestimmung der Strahldivergenz nur derjenige Bereich des Laserstrahls 10 beachtet wurde, der 95 % der Ausgangsleistung einschließt. Wie aus der Figur ersichtlich, wächst die horizontale Strahldivergenz mit steigender Ausgangsleistung des Lasers stark an. Dies erschwert den oben beschriebenen Einsatz des kantenemittierenden Halbleiterlaserchips für hohe Lichtleistungen, da die bevorzugt verwendeten kleinen Mikrooptiken 101 dann seitlich überstrahlt werden können und Licht verloren geht.

Die Figur 3 zeigt in einer schematischen Draufsicht einen kantenemittierenden Halbleiterlaserchip gemäß dem Stand der Technik.

Der kantenemittierende Halbleiterlaserchip 1 umfasst einen Halbleiterkörper 100, der eine Deckfläche 1a an seiner Oberseite aufweist. Auf der Deckfläche 1a ist ein strukturierter Kontaktstreifen aufgebracht. Der Kontaktstreifen 2 ist dabei in rhombenförmige Abschnitte unterteilt. Er weist eine Breite B von zirka 150 µm auf. Der kantenemittierende Halbleiterlaserchip zeichnet sich bei einer geringen Leistungs- beziehungsweise Stromdichte von 0,8 kA/cm2 durch eine deutliche Verringerung der lateralen Divergenz der emittierten elektromagnetischen Strahlung gegenüber einer Referenzstruktur aus, die einen umstrukturierten Kontaktstreifen 2 mit konstanter Breite B aufweist. Ein solcher Halbleiterlaserchip ist beispielsweise in der Veröffentlichung Baoxue et al., "Rhombus-like stripe BA InGaAs-AlGaAs-GaAs lasers", PTL 16, no. 5, 1248-1249 (2004) beschrieben.

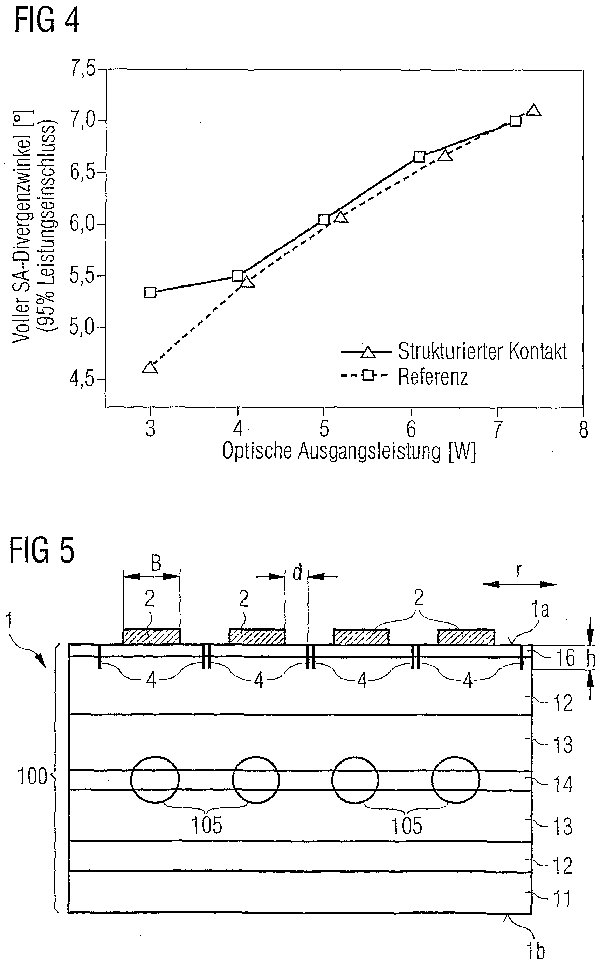

In der Figur 4 ist nun schematisch die Strahldivergenz gegen die optische Ausgangsleistung aufgetragen für einen Halbleiterlaserchip mit dem strukturierten Kontakt gemäß der Figur 3 sowie für einen Halbleiterlaserchip ohne strukturierten Kontakt, der als Referenzstruktur dient. 3 Watt optische Ausgangsleistung entsprechen dabei in etwa 0,8 kA/cm2 Stromdichte im kantenemittierenden Halbleiterlaserchip. 7 Watt optische Ausgangsleistung entsprechen in etwa 1,8 kA/cm2 Stromdichte im Halbleiterlaserchip. Wie der Figur 4 zu entnehmen ist, verschwinden der Vorteil geringer Strahldivergenz bei höheren optischen Ausgangsleistungen ab zirka 4 Watt. Ein Halbleiterlaserchip mit rhombenförmig strukturiertem Kontaktstreifen 2 bietet also für hohe optische Ausgangsleistungen und damit hohe Strömdichten keinen Vorteil hinsichtlich einer verringerten Strahldivergenz.

In Verbindung mit den folgenden Figuren werden nun Maßnahmen näher erläutert, durch die auch bei hohen optischen Ausgangsleistungen von mehreren Watt und bei einer Emitterbreite von zirka 100 µm eine wirksame Verringerung der horizontalen Strahldivergenz gegenüber herkömmlichen kantenemittierenden Halbleiterlaserchips erreicht werden kann.

Die Figur 5 zeigt eine schematische Schnittdarstellung eines Ausführungsbeispiels eines hier beschriebenen Halbleiterlaserchips 1. Beim hier beschriebenen kantenemittierenden Halbleiterlaserchip 1 handelt es sich vorzugsweise um einen so genannten Breitstreifenlaser. Breitstreifenlaser arbeiten lateral multimodig und neigen speziell bei hohen optischen Ausgangsleistungen zur Filamentierung. Das heißt, es treten lokale Leistungsüberhöhungen bei gleichzeitiger Verringerung der räumlichen Kohärenz der erzeugten elektromagnetischen Strahlung 10 auf. Ferner neigen Breitstreifenlaser zur Verkrümmung der Phasenfront der erzeugten elektromagnetischen Strahlung 10, was zu einer Verbreiterung der Strahldivergenz in lateraler Richtung führt.

Der hier beschriebene kantenemittierende Halbleiterlaserchip 1 kann dabei in unterschiedlichen Materialsystemen gefertigt sein. Beispielsweise handelt es sich um einen Halbleiterlaserchip, der auf einem der folgenden Halbleitermaterialien basiert: GaP, GaAsP, GaAs, GaAlAs, InGaAsP, GaN, InGaN, AlGaInAsSb. Darüber hinaus sind auch weitere Halbleitermaterialien aus den III-V- oder den II-VI-Halbleitersystemen denkbar. Zum Beispiel basiert der Halbleiterlaserchip auf dem AlGaInAs-Materialsystem. "Basiert" bedeutet dabei, dass zumindest eine Schicht des Halbleiterkörpers aus einem der genannten Materialien gebildet ist. Die Schicht kann zusätzlich Dotierstoffe enthalten.

Bei dem kantenemittierenden Halbleiterlaserchip 1 handelt es sich beispielsweise um einen Diodenlaser mit einer Vielzahl von Emittern, zum Beispiel mit vier bis sechs Emittern, welche eine Resonatorlänge größer 1 mm, zum Beispiel zwischen 1,5 und 6 mm, aufweist. Die Breite der von den einzelnen Emittern 105 erzeugten Strahlung 10 beträgt vorzugsweise zwischen 50 µm und 150 µm in lateraler Richtung r. Dabei ist es auch möglich, dass der kantenemittierende Halbleiterlaserchip einen einzigen Emitter umfasst.

Auf der Deckfläche 1a des Halbleiterkörpers 100 des kantenemittierenden Halbleiterlaserchips 1 befinden sich Kontaktstreifen 2, wobei jeder Kontaktstreifen 2 einem Emitter 105 zugeordnet ist. Der kantenemittierende Halbleiterlaserchip kann im Betrieb elektromagnetische Strahlung 10 im Spektralbereich von Infrarotstrahlung bis UV-Strahlung erzeugen.

Ein kantenemittierender Halbleiterlaserchip 1 für hohe Ausgangsleistungen im Spektralbereich von Infrarotstrahlung besitzt im Gegensatz zu Lasern für geringere Ausgangsleistungen sehr dicke Wellenleiterschichten 13, deren Dicke im Bereich von mehreren Mikrometer liegen kann.

Insbesondere bei diesen Infrarot emittierenden kantenemittierenden Halbleiterlaserchips 1 tritt folgendes Problem auf:
Diese Halbleiterlaserchips 1 weisen sehr dicke Wellenleiterschichten auf. Aufgrund der hohen Stromaufweitung in der dicken Wellenleiterschicht 13 zwischen der aktiven Zone 14 und dem Kontaktstreifen 2 bildet sich die Strukturierung eines Kontaktstreifens 2, wie sie in Verbindung mit der Figur 3 erläutert ist, nicht mehr als Gewinnprofil bis in die aktive Zone 14 ab. Vielmehr wird die aktive Zone nahezu gleichmäßig bestromt, ähnlich als wenn der Kontaktstreifen 2 unstrukturiert wäre.

Der kantenemittierende Halbleiterlaserchip 1 umfasst einen Halbleiterkörper 100. Der Halbleiterkörper 100 umfasst ein Substrat 11, bei dem es sich beispielsweise um ein Aufwachssubstrat handeln kann, auf das die nachfolgenden Schichten des Halbleiterkörpers 100 epitaktisch abgeschieden sind. Über das Substrat 11 kann der kantenemittierende Halbleiterlaserchip 1 beispielsweise n-seitig kontaktiert werden.

Ferner umfasst der kantenemittierende Halbleiterlaserchip 1 in seinem Halbleiterkörper 100 eine aktive Zone 14, welche zur Erzeugung elektromagnetischer Strahlung vorgesehen ist. Die aktive Zone 14 kann dabei beispielsweise einen pn-Übergang, eine Doppelheterostruktur, eine Einfach-Quantentopfstruktur oder eine Mehrfach-Quantentopfstruktur zur Strahlungserzeugung umfassen. Die Bezeichnung Quantentopfstruktur entfaltet hier keine Bedeutung hinsichtlich der Dimensionalität der Quantisierung. Sie umfasst somit unter anderem Quantentröge, Quantendrähte und Quantenpunkte und jede Kombination dieser Strukturen.

Die aktive Zone 14 ist in Wellenleiterschichten 13 eingebettet, die einen höheren Bandabstand und einen geringeren Brechungsindex als die aktive Zone 14 aufweisen.

An die Wellenleiterschichten 13 grenzt jeweils eine Überzugs- oder Mantelschicht 12 an, die sich durch einen höheren Bandabstand und einen geringeren Brechungsindex als die Wellenleiterschichten 13 von dieser unterscheiden.

Die dem Substrat 11 abgewandte Mantelschicht 12 grenzt an die Kontaktschicht 16 an, die höher p-leitend dotiert ist als die darunter liegende Mantelschicht 12. Auf der Deckfläche 1a des Halbleiterkörpers 100, direkt an die Kontaktschicht 16 grenzend, sind die Kontaktstreifen 2 aufgebracht. Die Kontaktstreifen 2 sind beispielsweise durch eine Metallisierung gebildet. Über die Kontaktstreifen 2 wird elektrischer Strom in die aktive Zone 14 des Halbleiterlaserchips 1 eingeprägt. Die Breite B der Kontaktstreifen 2 beträgt vorzugsweise zwischen wenigstens 10 µm und mehreren hundert µm, beispielsweise zirka 100 µm.

Seitlich, das heißt in lateraler Richtung r beabstandet zu den Kontaktstreifen 2, sind Begrenzungsstrukturen 4 angeordnet, welche zur Begrenzung der Stromaufweitung zwischen den Kontaktstreifen 2 und der aktiven Zone 14 dienen. Die Begrenzungsstrukturen 4 sind dabei beidseitig von jedem Kontaktstreifen 2 angeordnet.

Im Ausführungsbeispiel der Figur 5 erstrecken sich die Begrenzungsstrukturen über eine Eindringtiefe h in den Halbleiterkörper 100. Im Ausführungsbeispiel der Figur 5 reichen die Begrenzungsstrukturen 4 dabei bis in die Mantelschicht 12 und durchstoßen auf diese Weise die Kontaktschicht 16 vollständig. Beispielsweise reichen die Begrenzungsstrukturen bis zu einer Tiefe von 300 nm über der Wellenleiterschicht 13 in die Mantelschicht 12 hinein. Die Wellenleiterschicht 13 ist dann frei von Begrenzungsstrukturen 4.

Alternativ ist es jedoch auch möglich, dass die Begrenzungsstrukturen bis in die Wellenleiterschicht 13 hinein reichen. Die Begrenzungsstrukturen 4 reichen jedoch nicht bis zur aktiven Zone 14, so dass die aktive Zone 14 in jedem Fall frei von den Begrenzungsstrukturen ist. Beispielsweise reichen die Begrenzungsstrukturen 4 dann bis zu einer Tiefe von 300 nm über der aktiven Zone in die der Deckfläche 1a zugewandte Wellenleiterschicht 13.

Aufgrund der Begrenzungsstrukturen 4 wird eine unkontrollierte Stromaufweitung zwischen den Kontaktstreifen und der aktiven Zone 14 unterbunden. Das heißt, die zu große Stromaufweitung zwischen Kontaktstreifen 2 und aktiver Zone 14, wie dies bei dicker Wellenleiterschicht 13 auch für einen strukturierten Kontaktstreifen 2 der Fall wäre, wird durch die Begrenzungsstrukturen 4 verhindert. Auf diese Weise stellt sich ein geeignetes laterales und longitudinales Gewinn- beziehungsweise Ladungsträgerprofil in der aktiven Zone 14 ein. Dies führt zu einer Vergrößerung des Überlapps des lateralen Gewinnprofils in der aktiven Zone 14 mit niederen Lateralmoden, beispielsweise der lateralen Grundmode, und Verringerung des Überlapps für höhere Moden. Ferner führt das Gewinn- beziehungsweise Ladungsträgerprofil in der aktiven Zone 14 über den Plasma-Effekt im Randbereich des Emitters 105 zu einer entsprechend räumlichen Variation des Brechungsindex in der aktiven Zone 14, wodurch die erzeugte elektromagnetische Strahlung 10 gestreut und mit Verlusten beaufschlagt wird. Dies wirkt sich insbesondere auf höhere laterale Moden aus. Niedrigere laterale Moden - beispielsweise die laterale Grundmode - sind dadurch kaum beeinflusst. Insgesamt wird durch die vorgeschlagene Struktur also ein Verstärken der niederen lateralen Moden - beispielsweise der lateralen Grundmode - bevorzugt.

Die Begrenzungsstrukturen 4 befinden sich dabei in einem Abstand d von dem Kontaktstreifen 2. Vorzugsweise beträgt der Abstand d höchstens 30 µm.

Bei den Begrenzungsstrukturen 4 kann es sich beispielsweise um eine Ausnehmung handeln, die durch Ätzen erzeugt werden kann. Das heißt, zur Unterdrückung der Stromaufweitung wird die hochdotierte Kontaktschicht 16 sowie gegebenenfalls Teile der Mantel- und Wellenleiterschichten 12 und 13 strukturiert entfernt.

Anstatt oder zusätzlich zu einer Ätzung können die Begrenzungsstrukturen 4 auch durch eine Implantation von Ionen in das Kristallgitter des Halbleiterkörpers 100 erfolgen. Dadurch wird die elektrische Leitfähigkeit der mit Ionen implantierten Bereiche stark verringert und die Stromaufweitung weitgehend verhindert, so dass sich das implantierte Profil der Begrenzungsstrukturen 4 als Gewinnprofil in die aktive Zone 14 abbildet.

Handelt es sich bei den Begrenzungsstrukturen 4 um besonders tiefe Ausnehmungen, die bis in die Wellenleiterschicht 13 reichen, wird zusätzlich zum durch das Ladungsträgerprofil in der aktiven Zone 14 induzierte Brechzahlgitter ein optisches Gitter durch die räumliche Änderung der effektiven Brechzahl der Moden aufgrund der Begrenzungsstrukturen 4 erzeugt, da evaneszente vertikale Ausläufer der Welle der erzeugten elektromagnetischen Strahlung 10 bereichsweise statt in der Wellenleiterschicht 13 oder der Mantelschicht 12 in den Begrenzungsstrukturen 14 propagieren. Dabei kann beispielsweise in Ausnehmungen, welche die Begrenzungsstrukturen 4 bilden, ein Füllmaterial 41 eingebracht sein.

Handelt es sich bei den Begrenzungsstrukturen 4 um Ausnehmungen, die geätzt werden, so können die Begrenzungsstrukturen in mehreren Schritten erzeugt werden. Das heißt, die Begrenzungsstrukturen 4 können in einer Abfolge mehrerer Ätzschritte im Halbleiterkörper 100 erzeugt werden. Auf diese Weise kann ein mehrstufiges Höhenprofil in der Ausnehmung erzeugt werden. Die Ausnehmung kann dabei in lateraler Richtung und in longitudinaler Richtung - also in Richtung der Haupterstreckungsrichtung der Kontaktstreifen 2 - unterschiedlich strukturiert sein. Alternativ ist es auch möglich, dass die Ausnehmung beispielsweise durch einen entsprechenden Maskenprozess in einem einzigen Ätzschritt erzeugt wird. Ferner ist es möglich, dass die Ausnehmung, welche eine Begrenzungsstruktur bildet, sich in den einzelnen Schichten, wie Kontaktschicht 16, Mantelschicht 12 oder Wellenleiterschicht 13, in ihrem Höhenprofil unterscheidet.

Das heißt, die Ausnehmung kann in den unterschiedlichen Schichten beispielsweise unterschiedliche kontinuierliche Flankenwinkel aufweisen.

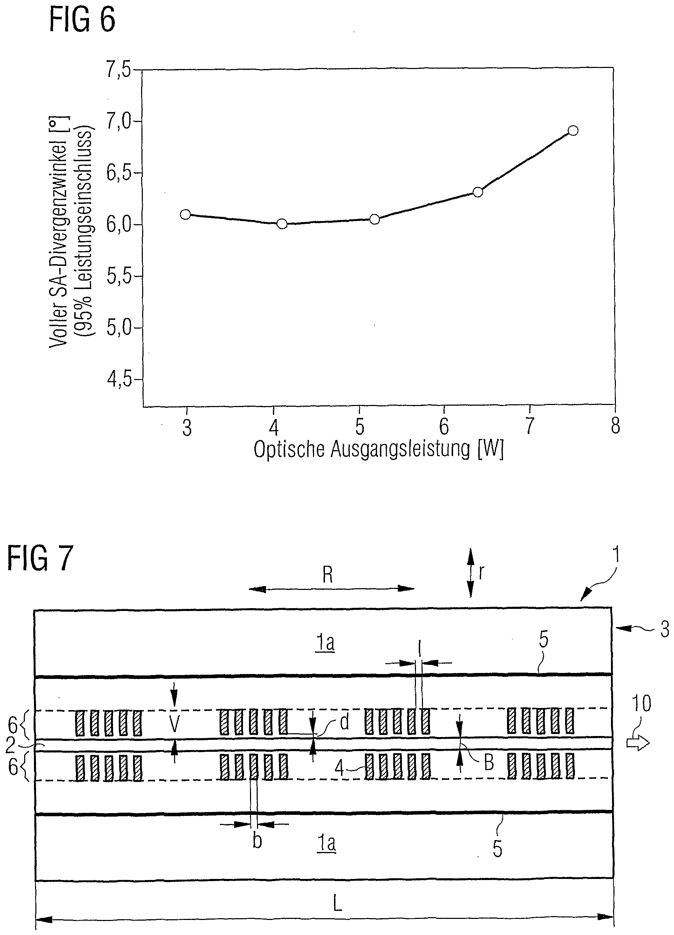

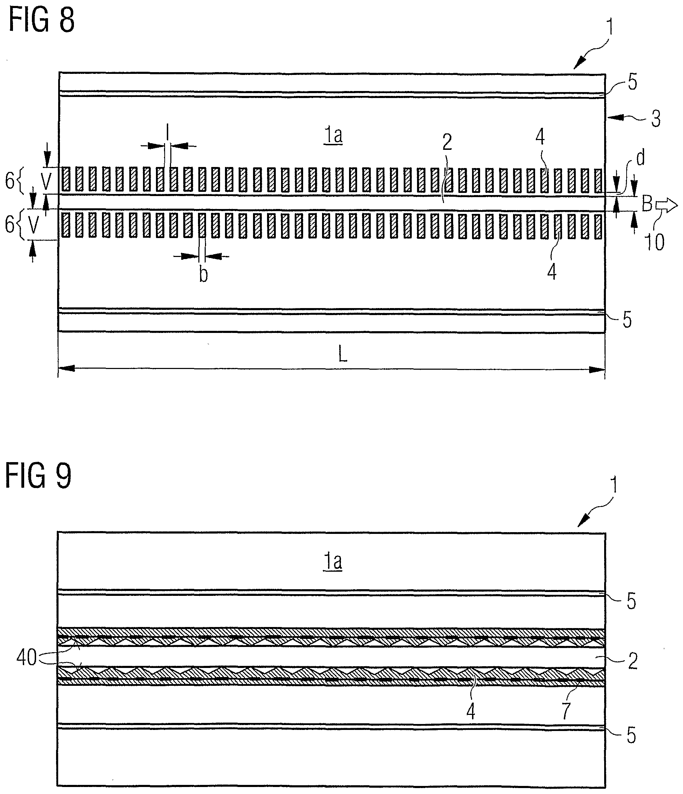

Die Figur 6 zeigt eine graphische Auftragung des Divergenzwinkels der erzeugten elektromagnetischen Strahlung 10 gegen die optische Ausgangsleistung für einen kantenemittierenden Halbleiterlaser 5, wie er in Verbindung mit den Figuren 5 und 8 beschrieben ist.

Der Abstand 1 der Begrenzungsstrukturen 4 auf einer Seite des Kontaktstreifens 2 beträgt dabei 10 µm. Die maximale Breite b der Begrenzungsstrukturen 4 beträgt jeweils 10 µm. Der Abstand d der Begrenzungsstrukturen 4 vom Kontaktstreifen 2 beträgt 6 µm.

Die Breite des Kontaktstreifens B beträgt 70 µm. Der Kontaktstreifen 2 ist als Metallisierung der Deckfläche la des Halbleiterkörpers 100 im Durchbruch einer Passivierungsschicht (nicht dargestellt) aus Siliziumnitrid ausgebildet.

Die Begrenzungsstrukturen 4 sind in einem Begrenzungsstreifen 6 beidseitig vom Kontaktstreifen 2 angeordnet, der eine Breite V von 60 µm aufweist. Die Begrenzungsstrukturen 4 sind durch die Kontaktschicht 16 hindurch in die Mantelschicht 12 als Rechtecke geätzt, wobei die Eindringtiefe h derart gewählt ist, dass die Begrenzungsstrukturen bis 300 nm vor die der Deckfläche 1a zugewandte Wellenleiterschicht 13 reichen. Der Füllfaktor, mit dem die Begrenzungsstrukturen 4 entlang des Kontaktstreifens 2 angeordnet sind, beträgt 50 %. Als Füllfaktor der Begrenzungsstruktur 4 wird das Verhältnis der Summe der maximalen Breiten b der Begrenzungsstrukturen 4 entlang der Haupterstreckungsrichtung R zur Gesamtlänge L des Kontaktstreifens 2 verstanden. Die Gesamtlänge L des Kontaktstreifens 2 beträgt dabei beispielsweise 4 mm.
Der Abstand D der Strombarrieren 5 vom Kontaktstreifen 2 beträgt 100 µm.

Der Halbleiterlaser 1 umfasst 5 Emitter, die im Abstand (so genannter Pitch) von 1 mm voneinander angeordnet sind.

In diesem Ausführungsbeispiel sind die Gradienten des Gewinnprofils in lateraler Richtung eher flach im Vergleich zum Gewinnprofil in longitudinaler Richtung R. Wie aus der Auftragung der Figur 6 ersichtlich ist, zeigt sich eine Verringerung der Strahldivergenz in lateraler Richtung (slow axis Richtung; SA) für hohe optische Ausgangsleistungen. Die Effizienz des kantenemittierenden Halbleiterlasers und der Vergleichsstruktur ohne Begrenzungsstrukturen 4 ist gleich.

In Verbindung mit der Figur 7 ist anhand einer schematischen Draufsicht ein weiteres Ausführungsbeispiel eines hier beschriebenen kantenemittierenden Halbleiterlaserchips näher erläutert. Im Unterschied zum Ausführungsbeispiel der Figuren 5 und 8 sind in diesem Ausführungsbeispiel die Begrenzungsstrukturen 4 in mehreren Gruppen angeordnet, die jeweils voneinander einen Abstand aufweisen, der größer ist als der Abstand 1 der Begrenzungsstrukturen in einer Gruppe. Eine derartige Struktur zeichnet sich im Vergleich zur in Verbindung mit den Figuren 5 und 8 erläuterten Ausführung des Halbleiterlaserchips 1 dadurch aus, dass hier auch Begrenzungsstrukturen 4 zum Einsatz kommen können, die bis in die Wellenleiterschicht 13 reichen. Beim in Verbindung mit den Figuren 5 und 8 beschriebenen Ausführungsbeispiel würde eine solch tiefe Strukturierung aufgrund der größeren Anzahl von Begrenzungsstrukturen zu einer zu starken Streuung und/oder Dämpfung der umlaufenden elektromagnetischen Strahlung 10 führen.

Die Gewinnführung ist aufgrund der relativ hohen Stromaufweitung in den Gebieten, in denen beidseitig vom Kontaktstreifen 2 keine Begrenzungsstrukturen 4 vorhanden sind, weniger stark ausgeprägt als beim in Verbindung mit den Figuren 5 und 8 beschriebenen Ausführungsbeispiel.

In Verbindung mit der Figur 9 ist ein Ausführungsbeispiel eines hier beschriebenen kantenemittierenden Halbleiterlaserchips 1 näher erläutert, bei dem die Begrenzungsstrukturen 4 beidseitig vom Kontaktstreifen 2 jeweils in einem einzigen, zusammenhängenden Streifen angeordnet sind. Die Begrenzungsstrukturen 4 weisen dabei auf ihrer dem Kontaktstreifen 2 zugewandten Seite jeweils Seitenflächen 40 auf, die einen Winkel ungleich 0° mit der Haupterstreckungsrichtung R des Kontaktstreifens 2 einschließen. Im Vergleich beispielsweise mit den in Verbindung mit der Figur 8 erläuterten Ausführungsbeispiel zeichnet sich das in Verbindung mit der Figur 9 beschriebene Ausführungsbeispiel durch steile Gradienten des Gewinnprofils sowohl in lateraler Richtung r als auch in longitudinaler Richtung R aus. Es erfolgt in lateraler Richtung r ein steiler Abfall der Ladungsträgerdichte zu den Rändern der aktiven Zone, also mit steigendem Abstand zum Kontaktstreifen 2. In longitudinaler Richtung R wird das Gewinnprofil moduliert.

Die Begrenzungsstrukturen 4 sind als Ausnehmungen ausgeführt, die in lateraler Richtung r vom Kontaktstreifen 2 weggerichtet ab der Fülllinie 7 mit einem Füllmaterial 41 gefüllt sind. Das heißt, die Teile der Ausnehmung, die auf der dem Kontaktstreifen 2 zugewandten Seite der Fülllinie liegen, sind frei von dem Füllmaterial. Je tiefer die Begrenzungsstrukturen 4 dabei in den Halbleiterkörper 100 reichen, desto weiter weg ist die Fülllinie 7 vom Kontaktstreifen 2.

Beidseitig vom Kontaktstreifen 2 kann bei allen Ausführungsbeispielen des hier beschriebenen kantenemittierenden Halbleiterlaserchips 2 eine Strombarriere 5 angeordnet sein, welche eine Ausbreitung des Stroms über sie hinaus unterbindet. Beispielsweise handelt es sich bei der Strombarriere 5 um eine V-förmige Grabenätzung, die bis zur aktiven Zone 14 oder durch diese hindurch reicht. Über die Strombarriere 5 können die einzelnen Emitter 105 vollständig elektrisch und optisch voneinander entkoppelt werden.

Der Füllfaktur der Begrenzungsstrukturen 4 variiert in lateraler Richtung r. Das heißt, der Füllfaktor der Begrenzungsstrukturen 4 kann entlang einer gedachten Linie parallel zur Haupterstreckungsrichtung R für unterschiedliche Abstände der gedachten Linie vom Kontaktstreifen unterschiedliche Werte annehmen. Bereichsweise beträgt der Füllfaktor 100 %. An den dem Kontaktstreifen 2 zugewandten Seitenflächen der Begrenzungsstrukturen 4 beträgt der Füllfaktor erfindungsgemäß wenigstens 10 % und höchstens 90 %.

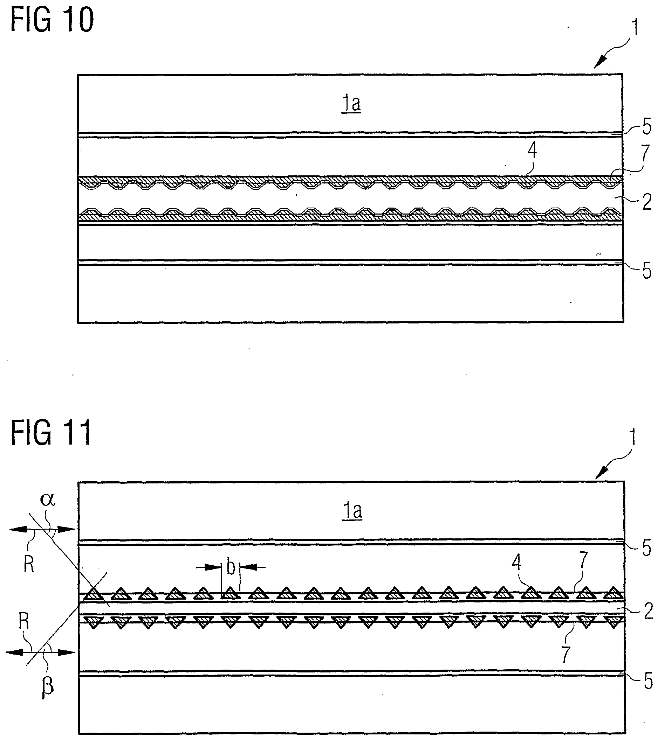

Die schematische Draufsicht der Figur 10 auf ein Ausführungsbeispiel eines hier beschriebenen kantenemittierenden Halbleiterlaserchips zeigt eine Variation des in Verbindung mit der Figur 9 beschriebenen Ausführungsbeispiels, wobei die Begrenzungsstrukturen 4 sich hinsichtlich der Variation des Füllfaktors in lateraler Richtung voneinander unterscheiden.

Der Füllfaktur der Begrenzungsstrukturen 4 variiert in lateraler Richtung r. Bereichsweise beträgt der Füllfaktor 100 %. An den dem Kontaktstreifen 2 zugewandten Seitenflächen der Begrenzungsstrukturen 4 beträgt der Füllfaktor bevorzugt wenigstens 10 % und höchstens 90 %.

In Verbindung mit der Figur 11 ist anhand einer schematischen Draufsicht ein weiteres Ausführungsbeispiel eines hier beschriebenen kantenemittierenden Halbleiterlaserchips 1 näher erläutert. Im Unterschied beispielsweise zum Ausführungsbeispiel der Figur 8, sind die Begrenzungsstrukturen 4 in diesem Ausführungsbeispiel in der Draufsicht auf die Deckfläche 1a des Halbleiterkörpers 100 des kantenemittierenden Halbleiterlaserchips 1 als Dreiecke, beispielsweise als gleichschenklige Dreiecke ausgebildet. Die Begrenzungsstrukturen 4 weisen damit eine Seitenfläche 40, die parallel zur Haupterstreckungsrichtung R des Kontaktstreifens 2 verläuft, sowie zwei Seitenflächen 40, die jeweils einen lateralen Flankenwinkel β von ungleich 90° mit der Haupterstreckungsrichtung R einschließen.

Die Begrenzungsstrukturen führen dabei sowohl in lateraler Richtung als in longitudinaler Richtung zu einem steilen Gradienten der Ladungsträgerdichte in der aktiven Zone, da sich der durch den Kontaktstreifen 2 eingeprägte elektrische Strom an den Begrenzungsstrukturen 4 vorbei in lateraler Richtung r auf eine relativ große Fläche ausbreiten kann. Beim Ausführungsbeispiel der Figur 11 weisen die Begrenzungsstrukturen jeweils mindestens zwei Seitenflächen 40 auf, wobei die Seitenflächen 40 mit der Haupterstreckungsrichtung R des Kontaktstreifens 2 einen Winkel β zwischen vorzugsweise wenigstens 15° und höchstens 75° einschließen. Dabei hat sich gezeigt, dass Flankenwinkel β von ungleich 90° bevorzugt sind.

Schließen die Seitenflächen 40 mit der Haupterstreckungsrichtung R einen Winkel von ungleich 90° ein, so wird die erzeugte elektromagnetische Strahlung 10 auch zur Seite von der aktiven Zone 14 weggestreut. Ferner können die Gradienten des Gewinnprofils durch die Wahl des Winkels eingestellt werden. Die Strahlung kann beispielsweise zu einer Strombarriere 5 hingeleitet werden, wo sie absorbiert wird. Beispielsweise ist die Strombarriere 5 durch einen V-förmigen Graben gebildet, der mit einem absorbierenden Material wie Germanium gefüllt ist.

Flankenwinkel β zwischen 15° und 75° erweisen sich als bevorzugt. Bei zu kleinen Winkeln wird die Länge der Begrenzungsstrukturen zu groß und das erzeugte Gewinnprofil zu homogen.

Bei zu großen Flankenwinkeln hingegen, das heißt bei Flankenwinkeln β von größer als 75°, nimmt die Streuwirkung zur Seite hin, also weg von dem Kontaktstreifen 2, ab.

Zur Vermeidung von Ringresonanzen zwischen den Begrenzungsstrukturen oder zwischen den Begrenzungsstrukturen 4 und beispielsweise der Auskoppelfacette 3 des Halbleiterlaserchips 1 ist der Flankenwinkel β vorzugsweise ungleich 45°.

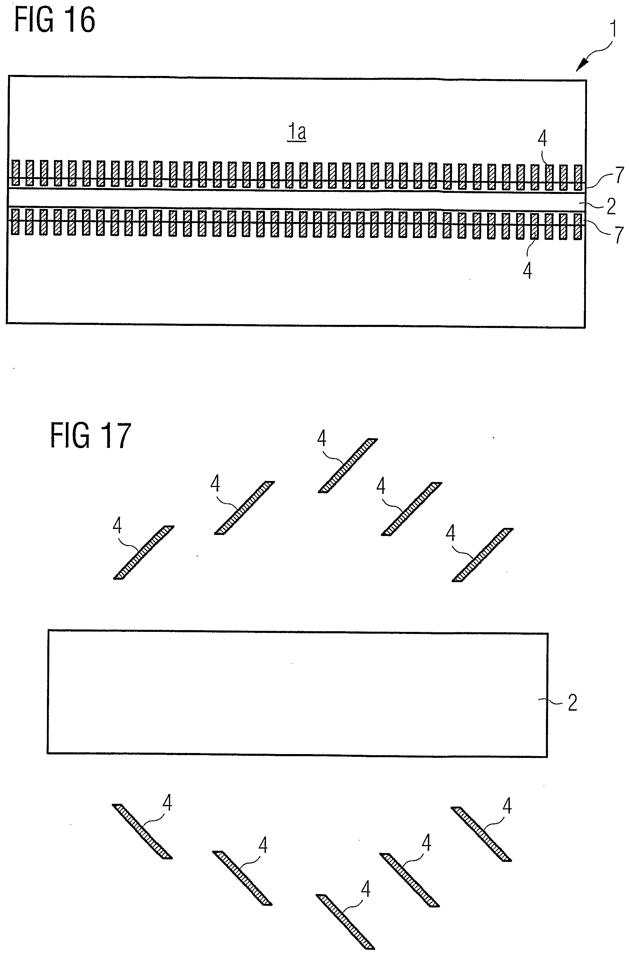

Alternativ zu einer solchen Wahl des Flankenwinkels können die Begrenzungsstrukturen 4 auch stufenartig angeordnet werden. Dies ist zum Beispiel in der Figur 17 dargestellt.

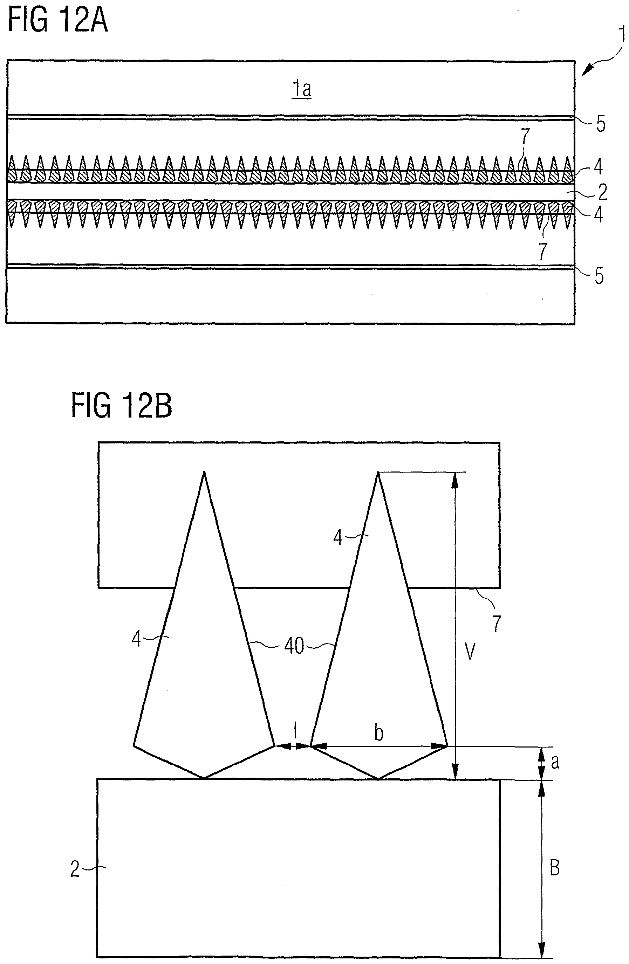

In Verbindung mit den Figuren 12a und 12b ist ein weiteres Ausführungsbeispiel eines hier beschriebenen kantenemittierenden Halbleiterlaserchips näher erläutert. In diesem Ausführungsbeispiel weisen die Begrenzungsstrukturen die Form von stilisierten Christbäumen auf. Das heißt, die Begrenzungsstrukturen weisen vier Ecken auf. Die Seitenflächen 40 der Begrenzungsstrukturen weisen dabei an der dem Kontaktstreifen 2 zugewandten Ende der Begrenzungsstruktur 4 einen flacheren Winkel auf als am dem Kontaktstreifen 2 abgewandten Ende der Begrenzungsstruktur.

Der Abstand d zwischen den Begrenzungsstrukturen 4 beträgt zum Beispiel 10 µm. Der Abstand a beträgt 10 µm. Die Breite V des Begrenzungsstreifens beträgt 80 µm. Die maximale Breite b der Begrenzungsstrukturen 4 beträgt 40 µm. Die Begrenzungsstrukturen 4 sind ab der Fülllinie 7 mit Germanium gefüllt. Die Breite B des Kontaktstreifens 2 beträgt 70 µm.

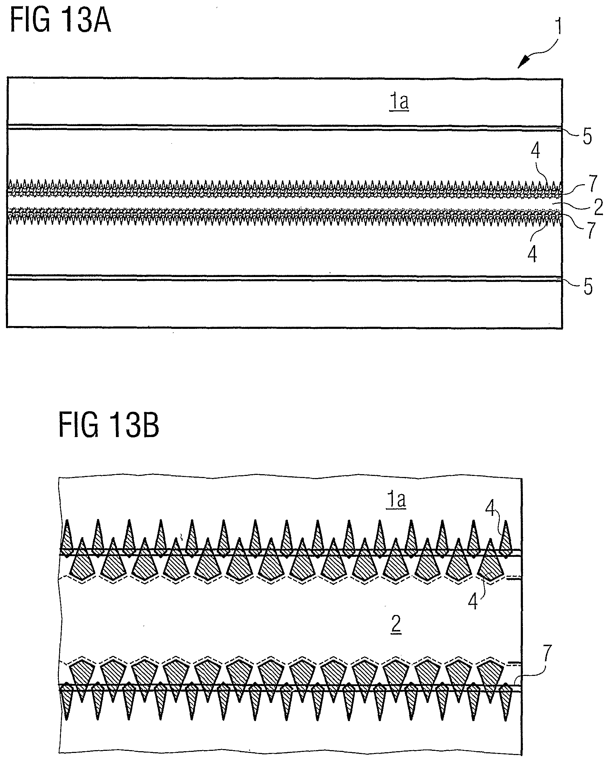

Im in Verbindung mit den Figuren 13a und 13b beschriebenen Ausführungsbeispiel des hier beschriebenen kantenemittierenden Halbleiterlaserchips sind die Begrenzungsstrukturen abwechselnd durch christbaumähnliche Strukturen gebildet, die sich in ihrer Größe unterscheiden. Die Begrenzungsstrukturen sind dabei symmetrisch zum Kontaktstreifen 2 beidseitig von diesem angeordnet. Der Kontaktstreifen 2 selbst weist an seinen den Begrenzungsstrukturen 4 zugewandten Seitenflächen eine wellenförmige Strukturierung auf, durch welche die gewünschte Stromeinprägung in die aktive Zone weiter verbessert wird.

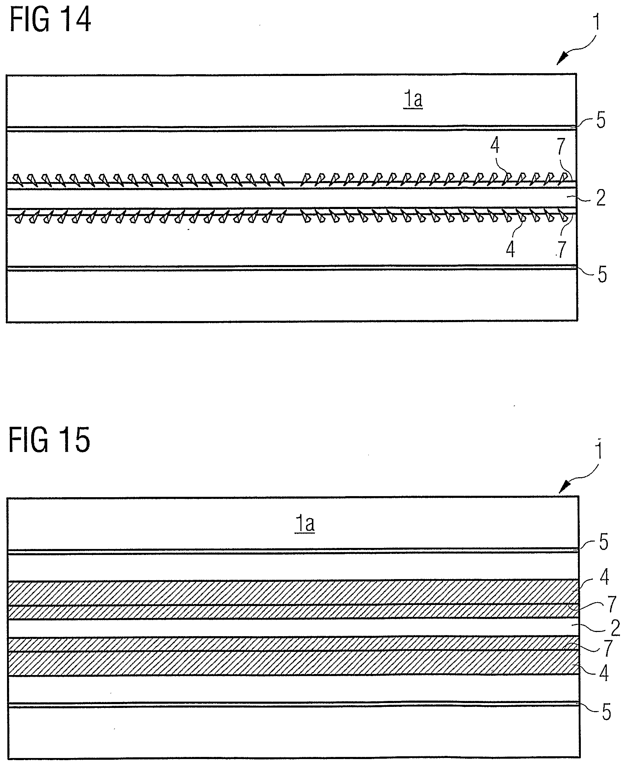

In der Draufsicht der Figur 14 ist schematisch ein weiteres Ausführungsbeispiel eines hier beschriebenen kantenemittierenden Halbleiterlaserchips dargestellt, bei dem die Begrenzungsstrukturen 4 durch keilförmige Strukturen gebildet sind, die derart ausgerichtet sind, dass sämtliche Seitenflächen 40 der Begrenzungsstrukturen 4 laterale Flankenwinkel β ungleich 0° und laterale Flankenwinkel β ungleich 90° mit der Haupterstreckungsrichtung R des Kontaktstreifens einschließen. Dabei ändert sich die Orientierung der Begrenzungsstrukturen 4 bei der Mitte des Kontaktstreifens 2. Dies lässt die Begrenzungsstrukturen 4 für die im Resonator umlaufende Welle elektromagnetischer Strahlung 10 symmetrisch erscheinen.

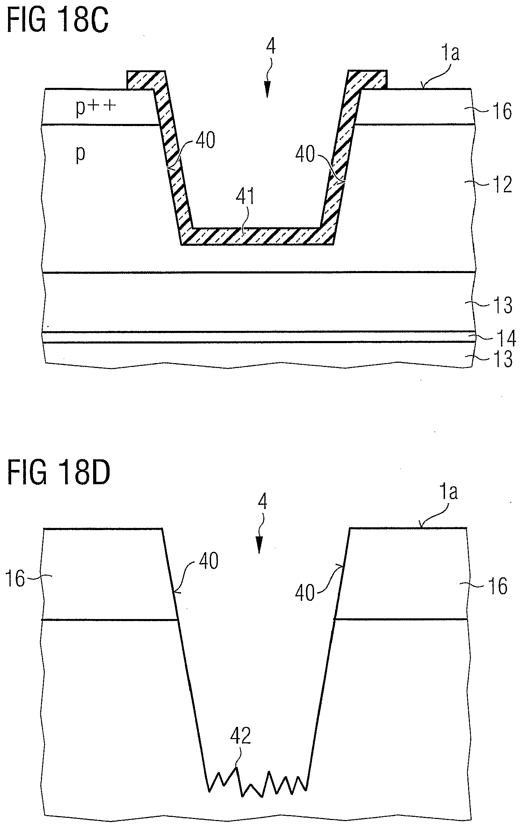

In der Verbindung mit der Figur 15 ist ein Ausführungsbeispiel erläutert, bei dem die Begrenzungsstruktur 4 eine Aufrauung 42 an der Bodenfläche einer Begrenzungsstruktur 4 aufweist. Bei der Aufrauung handelt es sich um eine statistische Aufrauung, wie sie beispielsweise in der Figur 18d anhand einer schematischen Schnittdarstellung erläutert ist. Die Aufrauung kann dabei zumindest stellenweise durch die Mantelschicht 12 hindurch bis in die Wellenleiterschicht 13 reichen. Die Aufrauung kann zum Beispiel durch trockenchemisches oder nasschemisches Ätzen erzeugt sein. Typische Strukturgrößen der Aufrauung betragen 50 nm bis 5µm, zum Beispiel zwischen 300 nm und 600 nm.

In Verbindung mit der Figur 16 ist anhand einer schematischen Draufsicht ein weiteres Ausführungsbeispiel eines hier beschriebenen kantenemittierenden Halbleiterlaserchips 1 näher erläutert. Im Unterschied beispielsweise zum Ausführungsbeispiel, das in der Figur 8 gezeigt ist, umfasst die Begrenzungsstruktur eine Aufrauung. Dabei kann die Begrenzungsstruktur 4 beispielsweise durch eine Ausnehmung gebildet sein, deren Boden aufgeraut ist, wie dies in Verbindung mit der Figur 18d gezeigt ist.

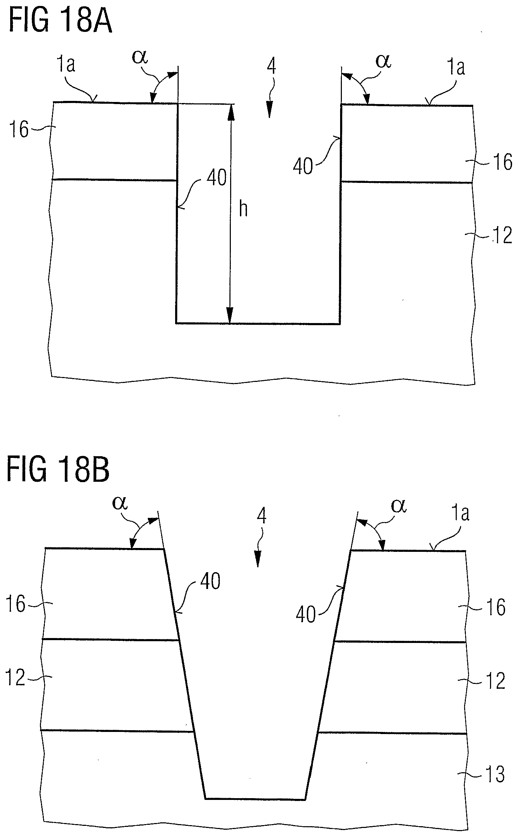

In den schematischen Schnittdarstellungen der Figuren 18a bis 18f sind Beispiele für die Ausgestaltung einer Begrenzungsstruktur 4 näher erläutert. Die gezeigten Begrenzungsstrukturen 4 können dabei bei jedem der gezeigten Ausführungsbeispiele des kantenemittierenden Halbleiterlaserchips Verwendung finden.

Beim in Verbindung mit der Figur 18a gezeigten Ausführungsbeispiel einer Begrenzungsstruktur 4 ist die Begrenzungsstruktur 4 als Ausnehmung in den Halbleiterkörper 100 strukturiert. Beispielsweise ist die Ausnehmung in den Halbleiterkörper 100 geätzt. Die Seitenflächen 40 der Begrenzungsstruktur 4 weisen dabei einen vertikalen Flankenwinkel α mit der Deckfläche 1a auf. Im Ausführungsbeispiel der Figur 18a beträgt der vertikale Flankenwinkel α=90°. Ein solcher Flankenwinkel kann beispielsweise gewählt werden, wenn die Ausnehmung nicht bis zum Wellenleiter reicht, sondern beispielsweise nur kurz unterhalb der Kontaktschicht 16 bis in die Mantelschicht 12.

In Verbindung mit der Figur 18b ist dahingegen ein Ausführungsbeispiel gezeigt, bei dem die Begrenzungsstruktur durch eine Ausnehmung gebildet ist, die bis in die Wellenleiterschicht 13 reicht. Bei einer derart großen Eindringtiefe h der Ausnehmung in den Halbleiterkörper 100 erfolgt eine Streuung der im Halbleiterlaserchip 1 umlaufenden Welle der elektromagnetischen Strahlung 10 an der Begrenzungsstruktur 4. Steile Flanken, das heißt vertikale Flankenwinkel α im Bereich von 90° sind dabei zu vermeiden, da die Welle sonst fast senkrecht zurückgestreut wird. Bevorzugt sind vertikale Flankenwinkel α zwischen 20° und 80°, da in diesem Fall kaum oder keine Reflexion der Welle beispielsweise in die Kontaktschicht 16 oder in das Substrat 11 erfolgt, wo die elektromagnetische Strahlung 10 absorbiert werden würde.

In Verbindung mit der Figur 18c ist ein Ausführungsbeispiel einer Begrenzungsstruktur 4 gezeigt, bei dem eine Ausnehmung mit einem Füllmaterial 41 gefüllt ist. Bei dem Füllmaterial 41 kann es sich beispielsweise um ein strahlungsabsorbierendes Material handeln, durch das neben dem Gewinnprofil in der aktiven Zone auch ein optisches Verlustprofil beidseitig vom Kontaktstreifen 2 erzeugt wird. Ferner kann es sich bei dem Füllmaterial um ein Material handeln, das eine höhere Brechzahl als das umgebende Material des Halbleiterkörpers 100 aufweist. Dadurch wird das Profil der im Halbleiterlaser anschwingenden Moden durch Antiguiding deformiert und weiter in den Außenbereich, weg vom Kontaktstreifen 2, gezogen, wo die Moden dann durch das Gewinnprofil stärker beeinflusst werden. Der Mechanismus des Antiguidings wirkt dabei stärker auf höhere laterale Moden als beispielsweise auf die laterale Grundmode. Das Füllmaterial 41 bedeckt vorzugsweise die Seitenflächen 40 sowie die Bodenfläche der Ausnehmung vollständig.

Der Effekt des Absorbierens und des Antiguidings kann durch die Wahl eines geeigneten Materials auch kombiniert werden. Dabei eignet sich beispielsweise als Füllmaterial amorphes Germanium, das eine hohe Brechzahl und eine hohe optische Absorption aufweist, besonders gut. Ferner kann auch ein Metall als Füllmaterial 41 Verwendung finden. Darüber hinaus ist es möglich, dass ein Halbleitermaterial mit kleinerer Bandlücke und größerer Brechzahl als der Halbleiterkörper 100 als Füllmaterial verwendet wird. Dieses Halbleitermaterial kann dann zum Beispiel epitaktisch in die Ausnehmung eingebracht werden.

In der Figur18d ist schematisch gezeigt, dass eine Begrenzungsstruktur 4 auch eine Aufrauung 42 umfassen kann. Durch die Aufrauung erhält man zusätzlich zu den Gewinnbeziehungsweise Verlustprofilen, die durch die Begrenzungsstruktur erzeugt werden, eine lokale Streuung in der Aufrauung 42, wodurch höhere laterale Moden weiter unterdrückt werden und Ring-Resonanzen aufgrund der statistischen Streuung an den Aufrauungen 42 unterbunden werden.

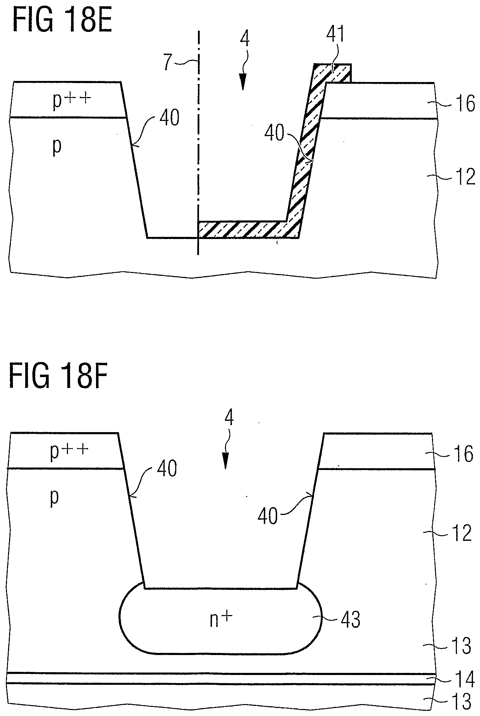

In Verbindung mit der Figur 18e ist anhand einer schematischen Schnittdarstellung eine Begrenzungsstruktur 4 erläutert, die nur teilweise, aber der Fülllinie 7 mit einem Füllmaterial 41 gefüllt ist. Dabei bleiben zum Beispiel zumindest die dem Kontaktstreifen 2 zugewandte Seitenfläche 40 frei vom Füllmaterial 41.

In Verbindung mit der Figur 18f ist anhand einer schematischen Schnittdarstellung eine Begrenzungsstruktur 4 erläutert, bei der zum Beispiel Germanium als Dotierstoff in den Diffusionsbereich 43 an der Bodenfläche der Ausnehmung eingebracht ist. Durch die Dotierung ist im Halbleiterkörper 100 ein hoch n-dotierter Bereich gebildet, der die Absorption der eintretenden elektromagnetischen Welle verstärken kann. Dabei ist es auch möglich, dass der Halbleiterkörper 100 im gesamten Bereich der Ausnehmung - also an Bodenfläche und Seitenflächen der Ausnehmung dotiert ist.

Die Erfindung ist nicht durch die Beschreibung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Kantenemittierender Halbleiterlaserchip (1) mit
- einem Halbleiterkörper (100), der zumindest eine aktive Zone (14) umfasst, in der im Betrieb des Halbleiterlaserchips (1) elektromagnetische Strahlung (10) erzeugt wird,
- zumindest einem Kontaktstreifen (2), der auf einer Deckfläche (la) an einer Oberseite des Halbleiterkörpers (100) angeordnet ist, und
- zumindest zwei Begrenzungsstrukturen (4) zur Begrenzung der Stromaufweitung zwischen dem Kontaktstreifen (2) und der aktiven Zone (14), wobei
- die Begrenzungsstrukturen (4) beidseitig vom Kontaktstreifen (2) angeordnet sind,
**dadurch gekennzeichnet, dass**
- die Begrenzungsstrukturen (4) mit einem Füllfaktor von wenigstens 10 % und höchstens 90 % beidseitig vom Kontaktstreifen (2) angeordnet sind und/oder eine Vielzahl von Begrenzungsstrukturen (4) in einer Haupterstreckungsrichtung (R) des Kontaktstreifens (2) beabstandet zueinander angeordnet sind.

2. Kantenemittierender Halbleiterlaserchip (1) nach dem vorherigen Anspruch,
bei dem zumindest eine Begrenzungsstruktur (4) eine Aufrauung (42) des Halbleiterkörpers (100) umfasst.

3. Kantenemittierender Halbleiterlaserchip (1) nach einem der vorherigen Ansprüche,
bei dem zumindest eine Begrenzungsstruktur (4) eine Seitenfläche (40) aufweist, die an den Halbleiterkörper (100) grenzt, wobei die Seitenfläche (40) mit der Deckfläche (la) des Halbleiterkörpers (100) einen Winkel (α) zwischen wenigstens 20° und höchstens 80° einschließt.

4. Kantenemittierender Halbleiterlaserchip (1) nach einem der vorherigen Ansprüche,
bei dem zumindest eine Begrenzungsstruktur (4) eine Seitenfläche (40) aufweist, die an den Halbleiterkörper (100) grenzt, wobei die Seitenfläche (40) mit der Haupterstreckungsrichtung (R) des Kontaktstreifens (2) einen Winkel (β) zwischen wenigstens 15° und höchstens 75° einschließt.

5. Kantenemittierender Halbleiterlaserchip (1) nach einem der vorherigen Ansprüche,
bei dem der Halbleiterkörper (100) aufweist:
- eine Kontaktschicht (16), die an den Kontaktstreifen (2) grenzt,
- eine Mantelschicht (15), die an die dem Kontaktstreifen (2) abgewandten Seite der Kontaktschicht (16) grenzt, und
- eine Wellenleiterschicht (13), die an die der Kontaktschicht (2) abgewandten Seite der Mantelschicht (15) grenzt, wobei
- sich zumindest eine der Begrenzungsstrukturen (4) bis in die Mantelschicht (15) erstreckt und die Wellenleiterschicht (13) frei von der Begrenzungsstruktur (4) ist.

6. Kantenemittierender Halbleiterlaserchip (1) nach einem der vorherigen Ansprüche,
bei dem sich zumindest eine Begrenzungsstruktur (4) in die Wellenleiterschicht (13) erstreckt und die aktive Zone (14) frei von der Begrenzungsstruktur (4) ist.

7. Kantenemittierender Halbleiterlaserchip (1) nach einem der vorherigen Ansprüche,
bei dem zumindest eine Begrenzungsstruktur (4) in einem Abstand (d) von höchstens 30 µm seitlich vom Kontaktstreifen (2) angeordnet ist.

8. Kantenemittierender Halbleiterlaserchip (1) nach einem der vorherigen Ansprüche,
bei dem die Begrenzungsstrukturen (4) in zwei Begrenzungsstreifen (6) beidseitig vom Kontaktstreifen (2) angeordnet sind, wobei die Begrenzungsstreifen (6) jeweils eine Breite (V) von höchstens 1 mm aufweisen.

9. Kantenemittierender Halbleiterlaserchip (1) nach einem der vorherigen Ansprüche,
bei dem zumindest eine Begrenzungsstruktur (4) durch ein Implantationsgebiet im Halbleiterkörper (100) gebildet ist.

10. Kantenemittierender Halbleiterlaserchip (1) nach einem der vorherigen Ansprüche,
bei dem zumindest eine Begrenzungsstruktur (4) durch eine Ausnehmung im Halbleiterkörper (100) gebildet ist.

11. Kantenemittierender Halbleiterlaserchip (1) nach dem vorherigen Anspruch,
bei dem die Ausnehmung mit zumindest einem Füllmaterial (41) gefüllt ist, das vom Halbleiterkörper (100) verschieden ist.

12. Kantenemittierender Halbleiterlaserchip (1) nach einem der vorherigen Ansprüche,
bei dem sich beidseitig vom Kontaktstreifen (2) entlang des Kontaktstreifens (2) je eine Strombarriere (5) erstreckt, wobei der Kontaktstreifen (2) und die Begrenzungsstrukturen (4) lateral zwischen den Strombarrieren (5) angeordnet sind.

## Claims

1. Edge emitting semiconductor laser chip (1) comprising
- a semiconductor body (100), which comprises at least one active zone (14) in which electromagnetic radiation (10) is generated during the operation of the semiconductor laser chip (1),
- at least one contact strip (2) arranged on a top surface (1a) at a top side of the semiconductor body (100), and
- at least two delimiting structures (4) for delimiting the current spreading between the contact strip (2) and the active zone (14), wherein
- the delimiting structures (4) are arranged on both sides of the contact strip (2),
**characterized in that**
- the delimiting structures (4) are arranged with a filling factor of at least 10% and at most 90% on both sides of the contact strip (2) and/or a multiplicity of delimiting structures (4) are arranged in a manner spaced apart from one another in a main extension direction (R) of the contact strip (2).

2. Edge emitting semiconductor laser chip (1) according to the preceding claim,
wherein at least one delimiting structure (4) comprises a roughening (42) of the semiconductor body (100).

3. Edge emitting semiconductor laser chip (1) according to either of the preceding claims,
wherein at least one delimiting structure (4) has a side surface (40) adjoining the semiconductor body (100), wherein the side surface (40) forms an angle (α) of between at least 20° and at most 80° with the top surface (1a) of the semiconductor body (100).

4. Edge emitting semiconductor laser chip (1) according to any of the preceding claims,
wherein at least one delimiting structure (4) has a side surface (40) adjoining the semiconductor body (100), wherein the side surface (40) forms an angle (β) of between at least 15° and at most 75° with the main extension direction (R) of the contact strip (2).

5. Edge emitting semiconductor laser chip (1) according to any of the preceding claims,
wherein the semiconductor body (100) comprises:
- a contact layer (16), which adjoins the contact strip (2),
- a cladding layer (15), which adjoins that side of the contact layer (16) which is remote from the contact strip (2), and
- a waveguide layer (13), which adjoins that side of the cladding layer (15) which is remote from the contact layer (2), wherein
- at least one of the delimiting structures (4) extends right into the cladding layer (15) and the waveguide layer (13) is free of the delimiting structure (4).

6. Edge emitting semiconductor laser chip (1) according to any of the preceding claims,
wherein at least one delimiting structure (4) extends into the waveguide layer (13) and the active zone (14) is free of the delimiting structure (4).

7. Edge emitting semiconductor laser chip (1) according to any of the preceding claims,
wherein at least one delimiting structure (4) is arranged at a distance (d) of at most 30 µm laterally with respect to the contact strip (2).

8. Edge emitting semiconductor laser chip (1) according to any of the preceding claims,
wherein the delimiting structures (4) are arranged in two delimiting strips (6) on both sides of the contact strip (2), wherein the delimiting strips (6) each have a width (V) of at most 1 mm.

9. Edge emitting semiconductor laser chip (1) according to any of the preceding claims,
wherein at least one delimiting structure (4) is formed by an implantation region in the semiconductor body (100).

10. Edge emitting semiconductor laser chip (1) according to any of the preceding claims,
wherein at least one delimiting structure (4) is formed by a cutout in the semiconductor body (100).

11. Edge emitting semiconductor laser chip (1) according to any of the preceding claims,
wherein the cutout is filled with at least one filling material (41) that is different than the semiconductor body (100).

12. Edge emitting semiconductor laser chip (1) according to any of the preceding claims,
wherein a respective current barrier (5) extends along the contact strip (2) on both sides of the contact strip (2), wherein the contact strip (2) and the delimiting structures (4) are arranged laterally between the current barriers (5).

## Revendications

1. Puce à semi-conducteur (1) à émission par le bord, comportant
- un corps à semi-conducteur (100) comprenant au moins une zone active (14) dans laquelle un rayonnement électromagnétique (10) est généré lors du fonctionnement de la puce à semi-conducteur (1),
- au moins une bande de contact (2) disposée sur une surface de couverture (la) au niveau d'une face supérieure du corps à semi-conducteur (100), et
- au moins deux structures de délimitation (4) destinées à délimiter la propagation du courant entre la bande de contact (2) et la zone active (14), dans lequel
- les structures de délimitation (4) sont disposées des deux côtés de la bande de contact (2),
**caractérisé en ce que**
- les structures de délimitation (4) sont disposées des deux côtés de la bande de contact (2) avec un facteur de remplissage d'au moins 10 % et d'au plus 90 % et/ou une pluralité de structures de délimitation (4) sont disposées de manière espacée les unes des autres dans une direction d'extension principale (R) de la bande de contact (2).

2. Puce à semi-conducteur à émission par le bord (1) selon la revendication précédente,
dans laquelle au moins une structure de délimitation (4) comprend le fait de rendre rugueux (42) le corps à semi-conducteur (100).

3. Puce à semi-conducteur à émission par le bord (1) selon l'une quelconque des revendications précédentes, dans laquelle au moins une structure de délimitation (4) comporte une surface latérale (40) adjacente au corps à semi-conducteur (100), dans laquelle la surface latérale (40) forme avec la surface de couverture (la) du corps à semi-conducteur (100) un angle (α) compris entre au moins 20° et au plus 80°.

4. Puce à semi-conducteur à émission par le bord (1) selon l'une quelconque des revendications précédentes, dans laquelle au moins une structure de délimitation (4) comporte une surface latérale (40) adjacente au corps à semi-conducteur (100), dans laquelle la surface latérale (40) forme avec la direction d'extension principale (R) de la bande de contact (2) un angle (β) compris entre au moins 15° et au plus 75°.

5. Puce à semi-conducteur à émission par le bord (1) selon l'une quelconque des revendications précédentes, dans laquelle le corps à semi-conducteur (100) comporte:
- une couche de contact (16) adjacente à la bande de contact (2),
- une couche de gaine (15) adjacente à la face de la couche de contact (16) qui est tournée en sens opposé à la bande de contact (2), et
- une couche de guide d'ondes (13) adjacente au côté de la couche de gaine (15) qui est tourné en sens opposé à la couche de contact (2),
dans laquelle
- au moins l'une des structures de délimitation (4) s'étend jusque dans la couche de gaine (15) et la couche de guide d'ondes (13) est dépourvue de la structure de délimitation (4).

6. Puce à semi-conducteur à émission par le bord (1) selon l'une quelconque des revendications précédentes, dans laquelle au moins une structure de délimitation (4) s'étend dans la couche de guide d'ondes (13) et la zone active (14) est dépourvue de la structure de délimitation (4).

7. Puce à semi-conducteur à émission par le bord (1) selon l'une quelconque des revendications précédentes, dans laquelle au moins une structure de délimitation (4) est disposée sur le côté de la bande de contact (2) à une distance (d) d'au plus 30 µm.

8. Puce à semi-conducteur à émission par le bord (1) selon l'une quelconque des revendications précédentes, dans laquelle les structures de délimitation (4) sont disposées dans deux bandes de délimitation (6) des deux côtés de la bande de contact (2), dans laquelle les bandes de délimitation (6) présentent respectivement une largeur (V) d'au plus 1 mm.

9. Puce à semi-conducteur à émission par le bord (1) selon l'une quelconque des revendications précédentes, dans laquelle au moins une structure de délimitation (4) est formée par un site d'implantation dans le corps à semi-conducteur (100).

10. Puce à semi-conducteur à émission par le bord (1) selon l'une quelconque des revendications précédentes, dans laquelle au moins une structure de délimitation (4) est formée par une cavité dans le corps à semi-conducteur (100).

11. Puce à semi-conducteur à émission par le bord (1) selon la revendication précédente,
dans laquelle la cavité est rempli d'au moins un matériau de remplissage (41) qui est différent du corps à semi-conducteur (100).

12. Puce à semi-conducteur à émission par le bord (1) selon l'une quelconque des revendications précédentes, dans laquelle une barrière de courant (5) s'étend respectivement des deux côtés de la bande de contact (2) le long de la bande de contact (2),
dans laquelle la bande de contact (2) et les structures de délimitation (4) sont disposées latéralement entre les barrières de courant (5).
